# EUROPEAN PATENT SPECIFICATION

(11) **EP 2 325 694 B1**
(45) Date of publication and mention of the grant of the patent: **08.11.2017**
(21) Application number: 09813128.7
(22) Date of filing: 10.09.2009
(51) Int. Cl.: G03F 7/039, G03F 7/004, G03F 7/38, H01L 21/027

(54) **RADIATION-SENSITIVE RESIN COMPOSITION, AND RESIST PATTERN FORMATION METHOD**
STRAHLUNGSEMPFINDLICHE HARZZUSAMMENSETZUNG UND VERFAHREN ZUR BILDUNG EINER RESISTSTRUKTUR
COMPOSITION DE RÉSINE RADIO-SENSIBLE ET PROCÉDÉ DE FORMATION D'UN MOTIF DE RÉSERVE

(30) Priority: 12.09.2008 JP 2008235509
(43) Date of publication of application: 25.05.2011
(73) Proprietor: JSR Corporation, Minato-ku Tokyo 105-8640 (JP)
(72) Inventor: NISHIMURA Yukio, Tokyo 105-8640 (JP); MATSUDA Yasuhiko, Tokyo 105-8640 (JP); NAKAGAWA Hiroki, Tokyo 105-8640 (JP); FUJISAWA Tomohisa, Tokyo 105-8640 (JP); HAMA Yukari, Tokyo 105-8640 (JP); KASAHARA Kazuki, Tokyo 105-8640 (JP)
(74) Representative: TBK
(86) International application number: PCT/JP2009/065875
(87) International publication number: WO 2010/029982

(56) References cited:
- WO-A1-2007/116664
- JP-A- 2008 069 146
- JP-A- 2008 116 496

## Description

### TECHNICAL FIELD

The present invention relates to a radiation-sensitive resin composition that may be used for photolithography employed in the production of semiconductor devices (e.g., IC), liquid crystal devices, circuit boards (e.g., thermal head), and the like, and also relates to a resist pattern-forming method. More specifically, the invention relates to a radiation-sensitive resin composition that may suitably be used for photolithography that utilizes an exposure light source having a wavelength of 220 nm or less (e.g., deep ultraviolet rays (e.g., ArF excimer laser light) or electron beams), and a resist pattern-forming method.

### BACKGROUND ART

When applying deep ultraviolet rays (e.g., KrF excimer laser light or ArF excimer laser light) or the like to a chemically-amplified radiation-sensitive resin composition, an acid is generated in the exposed area, and a difference in solubility rate in a developer occurs between the exposed area and the unexposed area due to chemical reactions catalyzed by the generated acid. A resist pattern is formed on a substrate by utilizing the difference in solubility rate.

When using a KrF excimer laser as the light source, an excellent pattern can be formed with high sensitivity and high resolution by utilizing a chemically-amplified radiation-sensitive resin composition that mainly includes a resin having a polyhydroxystyrene ("PHS") basic skeleton that has small absorption at 248 nm.

For example, an ArF excimer laser (wavelength: 193 nm) has been used as a light source having a shorter wavelength aimed at implementing more advanced microfabrication. It may be difficult to use a compound including an aromatic group (e.g., PHS) when using an ArF excimer laser as a light source due to large absorption at 193 nm (i.e., the wavelength of an ArF excimer laser). Therefore, a radiation-sensitive resin composition that includes a resin having an alicyclic hydrocarbon skeleton that does not have large absorption at 193 nm has been used as a lithographic material when using an ArF excimer laser.

A composition that includes a resin having an alicyclic hydrocarbon skeleton and including a repeating unit having a lactone skeleton exhibits significantly improved resolution (see Patent Documents 1 to 13, for example).

For example, Patent Documents 1 and 2 disclose a radiation-sensitive resin composition that includes a resin including a repeating unit having a mevalonic lactone skeleton or a γ-butyrolactone skeleton.

Patent Documents 3 to 13 disclose a radiation-sensitive resin composition that includes a resin including a repeating unit having an alicyclic lactone skeleton.

Patent Document 1: Japanese Patent Application Publication (KOKAI) No. 9-73173
Patent Document 2: United States Patent No. 6,388,101
Patent Document 3: Japanese Patent Application Publication (KOKAI) No. 2000-159758
Patent Document 4: Japanese Patent Application Publication (KOKAI) No. 2001-109154
Patent Document 5: Japanese Patent Application Publication (KOKAI) No. 2004-101642
Patent Document 6: Japanese Patent Application Publication (KOKAI) No. 2003-113174
Patent Document 7: Japanese Patent Application Publication (KOKAI) No. 2003-147023
Patent Document 8: Japanese Patent Application Publication (KOKAI) No. 2002-308866
Patent Document 9: Japanese Patent Application Publication (KOKAI) No. 2002-371114
Patent Document 10: Japanese Patent Application Publication (KOKAI) No. 2003-64134
Patent Document 11: Japanese Patent Application Publication (KOKAI) No. 2003-270787
Patent Document 12: Japanese Patent Application Publication (KOKAI) No. 2000-26446
Patent Document 13: Japanese Patent Application Publication (KOKAI) No. 2000-122294

WO2007116664 (A1) relates to a radiation-sensitive resin composition containing a fluorine-containing polymer (A) containing repeating units represented by the general formulae (1) and (2) below and having an Mw of 1,000-50,000, a resin (B) having an acid labile group, a radiation-sensitive acid generator (C), a nitrogen-containing compound (D) and a solvent (E). The solvent may inter alia be γ-butyrolactone.

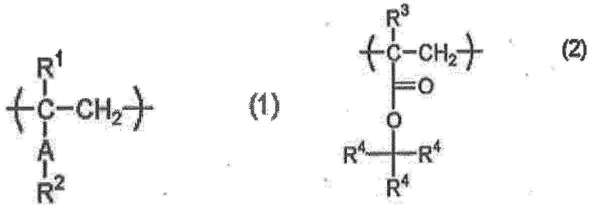

### DISCLOSURE OF THE INVENTION

### PROBLEMS TO BE SOLVED BY THE INVENTION

In order to implement a line width of 90 nm or less, however, it is difficult to satisfy the required resist performance using a radiation-sensitive resin composition for which the resolution is merely improved.

In order to implement further miniaturization, development of a material that exhibits excellent resolution, can suitably be used for liquid immersion lithography that has been put into practical use, and exhibits small line width roughness (LWR), high defect (e.g., blob defect) resistance, small post-exposure bake (PEB) temperature dependence, high pattern collapse resistance, and the like has been desired. In particular, development of a material that can suppress watermark defects and bubble defects that may occur during liquid immersion lithography has been desired.

Note that defects that may occur during liquid immersion lithography may be suppressed by forming a resist film having a highly water-repellent surface using a radiation-sensitive resin composition that includes a first resin that becomes alkali-soluble due to an acid, and does not include a fluorine atom, and a second resin that includes a repeating unit shown by a specific formula and a fluorine-containing repeating unit.

However, the resist performance (e.g., LWR, development defect resistance, and pattern collapse resistance) of the radiation-sensitive resin composition may deteriorate due to the second resin that includes a fluorine-containing repeating unit.

The invention was conceived in view of the above situation. An object of the invention is to provide a radiation-sensitive resin composition that produces an excellent pattern shape, exhibits excellent basic resist performance (e.g., sensitivity, resolution, LWR, development defect resistance, and pattern collapse resistance), and produces a resist film having a sufficiently water-repellent surface that suppresses watermark defects and bubble defects during liquid immersion lithography.

### MEANS FOR SOLVING THE PROBLEMS

The inventors conducted extensive studies in order to solve the above problems. As a result, the inventors found that the above problems can be solved by adding a lactone compound to a radiation-sensitive resin composition. This finding has led to completion of the invention.

Specifically, the invention provides the following.
[1] A radiation-sensitive resin composition including (A) a resin that includes a repeating unit that becomes alkali-soluble due to an acid, but does not include a fluorine-containing repeating unit, (B) a photoacid generator, (C) a fluorine-containing resin that includes a repeating unit that becomes alkali-soluble due to an acid, and a fluorine-containing repeating unit, and (D) a lactone compound, the content of the lactone compound (D) in the composition being, 50 to 200 parts by mass based on 100 parts by mass of the resin (A).
[2] The radiation-sensitive resin composition according to [1], wherein the content of the fluorine-containing resin (C) is 0.1 to 20 parts by mass based on 100 parts by mass of the resin (A).
[3] The radiation-sensitive resin composition according to [1] or [2], wherein the fluorine-containing resin (C) includes at least one of a repeating unit shown by the following general formula (8) and a repeating unit shown by the following general formula (9), 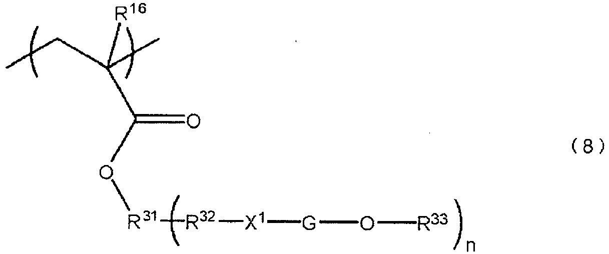 wherein R¹⁶ represents a hydrogen atom, an alkyl group having 1 to 4 carbon atoms, a trifluoromethyl group, or a hydroxymethyl group, R³¹ represents a single bond or an (n+1)-valent chain-like or cyclic hydrocarbon group, R³² individually represents a single bond or a divalent chain-like or cyclic hydrocarbon group, X¹ represents a methylene group substituted with a fluorine atom, or a linear or branched fluoroalkylene group having 2 to 20 carbon atoms, G represents a single bond or -CO-, n is an integer from 1 to 3, and R³³ represents a hydrogen atom or an acid-dissociable group, 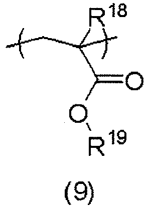 wherein R¹⁸ individually represent a hydrogen atom, an alkyl group having 1 to 4 carbon atoms, a trifluoromethyl group, or a hydroxymethyl group, and R¹⁹ represents a linear, branched, or cyclic alkyl group having 1 to 12 carbon atoms in which at least one hydrogen atom is substituted with a fluorine atom.
[4] The radiation-sensitive resin composition according to any one of [1] to [3], wherein the fluorine-containing resin (C) includes a repeating unit shown by the following general formula (1c-1), 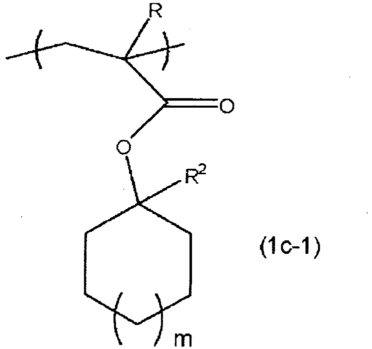 wherein R represents a hydrogen atom, an alkyl group having 1 to 4 carbon atoms, a trifluoromethyl group, or a hydroxymethyl group, R² represents a linear or branched alkyl group having 1 to 4 carbon atoms, and m is an integer from 0 to 4.
[5] The radiation-sensitive resin composition according to any one of [1] to [4], wherein the resin (A) further includes a repeating unit having a lactone skeleton.
[9] A resist pattern-forming method including:
   (1) forming a photoresist film on a substrate using the radiation-sensitive resin composition according to any one of [1] to [5];
   (2) subjecting the photoresist film to liquid immersion lithography; and
   (3) developing the photoresist film subjected to liquid immersion lithography to form a resist pattern.

### EFFECTS OF THE INVENTION

The above radiation-sensitive resin composition produces an excellent pattern shape, exhibits excellent basic resist performance (e.g., sensitivity, resolution, LWR, development defect resistance, and pattern collapse resistance), produces a resist film having a sufficiently water-repellent surface that suppresses watermark defects and bubble defects during liquid immersion lithography, and may suitably be used as a chemically-amplified resist. Therefore, the above radiation-sensitive resin composition may suitably be used for lithography (particularly lithography that includes liquid immersion lithography), and may preferably be used for lithography that utilizes an ArF excimer laser as a light source.

### DESCRIPTION OF EXEMPLARY EMBODIMENTS

Exemplary embodiments of the invention are described below. Note that the invention is not limited to the following embodiments. Specifically, various modifications, improvements, and the like may be made of the following embodiments without departing from the scope of the invention based on the common knowledge of a person having ordinary skill in the art.

Note that the term "(meth)acryl" used herein refers to acryl and methacryl, and the term "(meth)acrylate" used herein refers to an acrylate and a methacrylate.

### [1] Radiation-sensitive resin composition (I)

A radiation-sensitive resin composition according to one embodiment of the invention includes (A) a resin that includes a repeating unit that becomes alkali-soluble due to an acid, but does not include a fluorine-containing repeating unit, (B) a photoacid generator, (C) a fluorine-containing resin that includes a repeating unit that becomes alkali-soluble due to an acid, and a fluorine-containing repeating unit, and (D) a lactone compound (hereinafter may be referred to as "radiation-sensitive resin composition (I)").

Note that the radiation-sensitive resin composition (I) may further include an acid diffusion controller (hereinafter may be referred to as "acid diffusion controller (E)"), an additive (hereinafter may be referred to as "additive (F)"), a solvent (hereinafter may be referred as "solvent (G)"), and the like, in addition to the resin (A), the photoacid generator (B), the fluorine-containing resin (C), and the lactone compound (D).

Each component of the radiation-sensitive resin composition (I) is described in detail below.

### [1-1] Resin (A)

The resin (A) includes a repeating unit that becomes alkali-soluble due to an acid, but does not include a fluorine-containing repeating unit. Specifically, the resin (A) is insoluble or scarcely soluble in alkali, but becomes alkali-soluble due to an acid, and does not include a fluorine atom. The expression "insoluble or scarcely soluble in alkali" used herein means that a film that is formed only of the resin (A) has a thickness equal to or more than 50% of the initial thickness when developed under alkaline development conditions employed when forming a resist pattern using a photoresist film that is formed of a radiation-sensitive resin composition that includes the resin (A). The expression "does not include a fluorine atom" used herein means that introduction (incorporation) of a fluorine atom into the resin (A) is intentionally avoided when producing the resin (A).

The repeating unit that is included in the resin (A) and becomes alkali-soluble due to an acid (hereinafter may be referred to as "repeating unit (a1)") is not particularly limited, but may be a repeating unit that is normally included in a resin of a radiation-sensitive resin composition.

The resin (A) preferably includes a repeating unit that includes a group shown by the following general formula (1) (hereinafter referred to as "repeating unit (1)") as the repeating unit (a1). 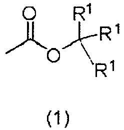 wherein R¹ individually represent a monovalent alicyclic hydrocarbon group having 4 to 20 carbon atoms, a derivative thereof, or a linear or branched alkyl group having 1 to 4 carbon atoms.

Specific examples of the monovalent alicyclic hydrocarbon group having 4 to 20 carbon atoms represented by R¹ in the general formula (1) include groups including an alicyclic ring derived from a cycloalkane (e.g., norbornane, tricyclodecane, tetracyclododecane, adamantane, cyclobutane, cyclopentane, cyclohexane, cycloheptane, or cyclooctane); groups obtained by substituting these groups with at least one linear, branched, or cyclic alkyl group having 1 to 4 carbon atoms (e.g., methyl group, ethyl group, n-propyl group, i-propyl group, n-butyl group, 2-methylpropyl group, 1-methylpropyl group, or t-butyl group); and the like. Note that two of R¹ may bond to form a divalent alicyclic hydrocarbon group or a derivative thereof together with the carbon atom that is bonded to the two R¹. Among these, groups including an alicyclic ring derived from norbornane, tricyclodecane, tetracyclododecane, adamantane, cyclopentane, or cyclohexane, and groups obtained by substituting these groups with a linear, branched, or cyclic alkyl group having 1 to 4 carbon atoms are preferable.

Specific examples of a derivative of the monovalent alicyclic hydrocarbon group having 4 to 20 carbon atoms represented by R¹ in the general formula (6) include groups including at least one substituent such as a hydroxyl group; a carboxyl group; an oxo group (=O), a hydroxyalkyl group having 1 to 4 carbon atoms such as a hydroxymethyl group, a 1-hydroxyethyl group, a 2-hydroxyethyl group, a 1-hydroxypropyl group, a 2-hydroxypropyl group, a 3-hydroxypropyl group, a 1-hydroxybutyl group, a 2-hydroxybutyl group, a 3-hydroxybutyl group, or a 4-hydroxybutyl group; an alkoxy group having 1 to 4 carbon atoms such as a methoxy group, an ethoxy group, an n-propoxy group, an i-propoxy group, an n-butoxy group, a 2-methylpropoxy group, a 1-methylpropoxy group, or a t-butoxy group; a cyano group; or a cyanoalkyl group having 2 to 5 carbon atoms such as a cyanomethyl group, a 2-cyanoethyl group, a 3-cyanopropyl group, or a 4-cyanobutyl group. Among these, a hydroxyl group, a carboxyl group, a hydroxymethyl group, a cyano group, a cyanomethyl group, and the like are preferable as the substituent.

Specific examples of the linear or branched alkyl group having 1 to 4 carbon atoms represented by R¹ in the general formula (3) include a methyl group, an ethyl group, an n-propyl group, an i-propyl group, an n-butyl group, a 2-methylpropyl group, a 1-methylpropyl group, a t-butyl group, and the like. Among these, a methyl group, an ethyl group, an n-propyl group, and an i-propyl group are preferable.

The group shown by the general formula (1) included in the repeating unit (1) is preferably a group shown by any of the following general formulas (1a) to (1d). 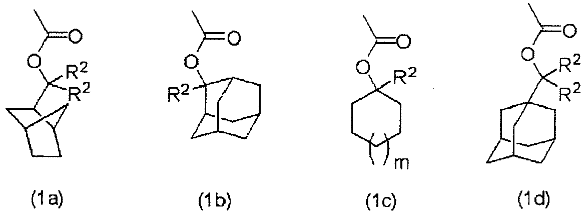 wherein R² individually represent a linear or branched alkyl group having 1 to 4 carbon atoms, and m is an integer from 0 or 4.

Specific examples of the linear or branched alkyl group having 1 to 4 carbon atoms represented by R² in the general formula (1a) to (1d) include a methyl group, an ethyl group, an n-propyl group, an i-propyl group, an n-butyl group, a 2-methylpropyl group, a 1-methylpropyl group, a t-butyl group, and the like. Among these, a methyl group, an ethyl group, an n-propyl group, and an i-propyl group are preferable.

It is preferable that each R² in the group shown by the general formula (1a) be a methyl group.

It is preferable that R² in the group shown by the general formula (1b) be a methyl group, an ethyl group, an n-propyl group, or an i-propyl group.

The group shown by the general formula (1c) is preferably a group in which m is 0 and R² is a methyl group, a group in which m is 0 and R² is an ethyl group, a group in which m is 1 and R² is a methyl group, or a group in which m is 1 and R² is an ethyl group.

It is preferable that each R² in the group shown by the general formula (1d) be a methyl group.

Further examples of the group shown by the general formula (1) included in the repeating unit (1) include a t-butoxycarbonyl group, groups shown by the following formulas (1e-1) to (1e-8), and the like.

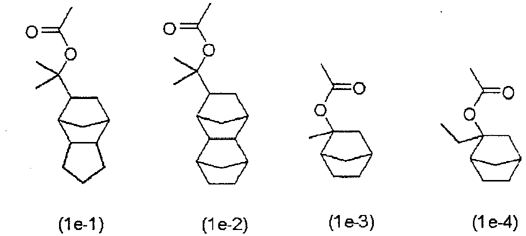

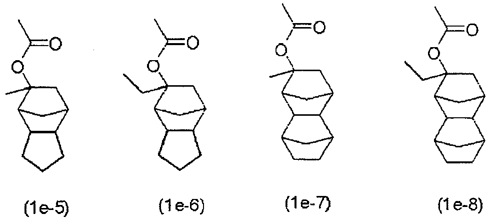

The main chain skeleton of the repeating unit (1) is not particularly limited, but preferably includes a (meth)acrylate structure or an α-trifluoroacrylate structure.

Examples of a preferable monomer that produces the repeating unit (1) include 2-methyladamant-2-yl (meth)acrylate, 2-methyl-3-hydroxyadamant-2-yl (meth)acrylate, 2-ethyladamant-2-yl (meth)acrylate, 2-ethyl-3-hydroxyadamant-2-yl (meth)acrylate, 2-n-propyladamant-2-yl (meth)acrylate, 2-isopropyladamant-2-yl (meth)acrylate,
2-methylbicyclo[2.2.1]hept-2-yl (meth)acrylate, 2-ethylbicyclo[2.2.1]hept-2-yl (meth)acrylate, 8-methyltricyclo[5.2.1.0^{2,6}]decan-8-yl (meth)acrylate, 8-ethyltricyclo[5.2.1.0 ^{2,6}]decan-8-yl (meth)acrylate, 4-methyltetracyclo[6.2.1^{3,6}0^{2,7}]dodecan-4-yl (meth)acrylate, 4-ethyltetracyclo[6.2.1^{3,6}.0^{2,7}]dodecan-4-yl (meth)acrylate, 1-(bicyclo[2.2.1]hept-2-yl)-1-methylethyl (meth)acrylate, 1-(tricyclo[5.2.1.0^{2,6}]decan-8-yl)-1-methylethyl (meth)acrylate, 1-(tetracyclo[6.2.1^{3,6}.0^{2,7}]dodecan-4-yl)-1-methylethyl (meth)acrylate,
1-(adamantan-1-yl)-1-methylethyl (meth)acrylate, 1-(3-hydroxyadamantan-1-yl)-1-methylethyl (meth)acrylate, 1,1-dicyclohexylethyl (meth)acrylate, 1,1-di(bicyclo[2.2.1]hept-2-yl)ethyl (meth)acrylate, 1,1-di(tricyclo[5.2.1.0^{2, 6}]decan-8-yl)ethyl (meth)acrylate, 1,1-di(tetracyclo[6.2.1^{3,6}.0^{2,7}]dodecan-4-yl)ethyl (meth)acrylate, 1,1-di(adamantan-1-yl)ethyl (meth)acrylate, 1-methyl-1-cyclopentyl (meth)acrylate, 1-ethyl-1-cyclopentyl (meth)acrylate, 1-methyl-1-cyclohexyl (meth)acrylate, 1-ethyl-1-cyclohexyl (meth)acrylate, and the like.

Among these monomers, 2-methyladamant-2-yl (meth)acrylate, 2-ethyladamant-2-yl (meth)acrylate, 2-methylbicyclo[2.2.1]hept-2-yl (meth)acrylate, 2-ethylbicyclo[2.2.1]hept-2-yl (meth)acrylate, 1-(bicyclo[2.2.1]hept-2-yl)-1-methylethyl (meth)acrylate, 1-(adamantan-1-yl)-1-methylethyl (meth)acrylate, 1-methyl-1-cyclopentyl (meth)acrylate, 1-ethyl-1-cyclopentyl (meth)acrylate, 1-methyl-1-cyclohexyl (meth)acrylate, 1-ethyl-1-cyclohexyl (meth)acrylate and the like are particularly preferable.

The resin (A) may include only one type of repeating unit (1), or may include two or more types of repeating unit (1).

The resin (A) preferably further includes a repeating unit having a lactone skeleton (hereinafter may be referred to as "repeating unit (2)") in order to increase the alkali solubility.

Examples of the repeating unit (2) include repeating units shown by the following general formulas (2-1) to (2-6), and the like. 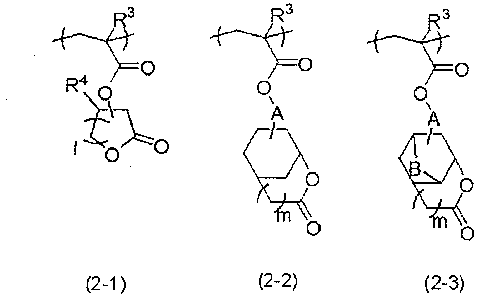 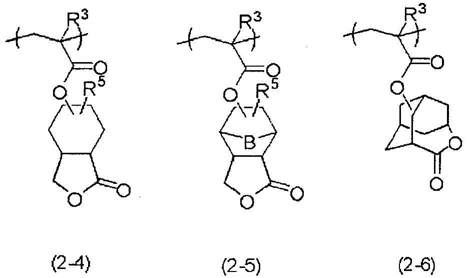 wherein R³ represents a hydrogen atom, a methyl group, or a trifluoromethyl group, R⁴ represents a hydrogen atom or a substituted or unsubstituted alkyl group having 1 to 4 carbon atoms, R⁵ represents a hydrogen atom or a methoxy group, A represents a single bond or a methylene group, B represents an oxygen atom or a methylene group, 1 is an integer from 1 to 3, and m is 0 or 1.

Specific examples of a preferable monomer that produces the repeating unit (2) include 5-oxo-4-oxa-tricyclo[4.2.1.0^{3,7}]non-2-yl (meth)acrylate, 9-methoxycarbonyl-5-oxo-4-oxa-tricyclo[4.2.1.0^{3,7}]non-2-yl (meth)acrylate, 5-oxo-4-oxatricyclo[5.2.1.0^{3,8}]dec-2-yl (meth)acrylate, 10-methoxycarbonyl-5-oxo-4-oxa-tricyclo[5.2.1.0^{3,8}]dec-2-yl (meth)acrylate,
6-oxo-7-oxa-bicyclo[3.2.1]oct-2-yl (meth)acrylate, 4-methoxycarbonyl-6-oxo-7-oxa-bicyclo[3.2.1]oct-2-yl (meth)acrylate, 7-oxo-8-oxa-bicyclo[3.3.1]oct-2-yl (meth)acrylate, 6-oxa-5-oxo[5.2.1.0^{2,6}]dec-2-yl (meth)acrylate, 3-methoxy-6-oxa-5-oxo[5.2.1.0^{2,6}]dec-2-yl (meth)acrylate, 6-oxa-5-oxo[4.3.0]non-2-yl (meth)acrylate, 3-methoxy-6-oxa-5-oxo[4.3.0]non-2-yl (meth)acrylate, 4-methoxycarbonyl-7-oxo-8-oxa-bicyclo[3.3.1]oct-2-yl (meth)acrylate,
2-oxotetrahydropyran-4-yl (meth)acrylate, 4-methyl-2-oxotetrahydropyran-4-yl (meth)acrylate, 4-ethyl-2-oxotetrahydropyran-4-yl (meth)acrylate, 4-propyl-2-oxotetrahydropyran-4-yl (meth)acrylate, 2-oxotetrahydrofuran-4-yl (meth)acrylate, 5,5-dimethyl-2-oxotetrahydrofuran-4-yl (meth)acrylate, 3,3-dimethyl-2-oxotetrahydrofuran-4-yl (meth)acrylate, 2-oxotetrahydrofuran-3-yl (meth)acrylate, 4,4-dimethyl-2-oxotetrahydrofuran-3-yl (meth)acrylate, 5,5-dimethyl-2-oxotetrahydrofuran-3-yl (meth)acrylate, 5-oxotetrahydrofuran-2-ylmethyl (meth)acrylate, 3,3-dimethyl-5-oxotetrahydrofuran-2-ylmethyl (meth)acrylate, and 4,4-dimethyl-5-oxotetrahydrofuran-2-ylmethyl (meth)acrylate.

The resin (A) may include only one type of repeating unit (2), or may include two or more types of repeating unit (2).

The resin (A) preferably includes at least one of a repeating unit shown by the following general formula (3) (hereinafter may be referred to as "repeating unit (3)") and a repeating unit shown by the following general formula (4) (hereinafter may be referred to as "repeating unit (4)") in addition to the repeating units (1) and (2). 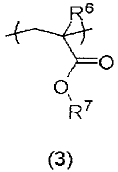 wherein R⁶ represents a hydrogen atom, a methyl group, or a trifluoromethyl group, and R⁷ represents a polyalicyclic hydrocarbon group having 7 to 20 carbon atoms. 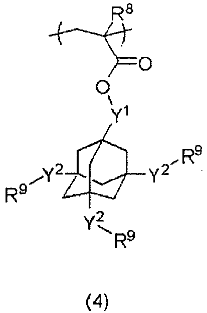 wherein R⁸ represents a hydrogen atom or a methyl group, Y¹ represents a single bond or a divalent organic group having 1 to 3 carbon atoms, Y² individually represent a single bond or a divalent organic group having 1 to 3 carbon atoms, and R⁹ individually represent a hydrogen atom, a hydroxyl group, a cyano group, or a group COOR¹⁰ (wherein R¹⁰ represents a hydrogen atom, a linear or branched alkyl group having 1 to 4 carbon atoms, or an alicyclic alkyl group having 3 to 20 carbon atoms).

R⁶ in the general formula (3) preferably represents a polyalicyclic hydrocarbon group having 7 to 20 carbon atoms. The polyalicyclic hydrocarbon group may be substituted with at least one substituent selected from the group consisting of an alkyl group having 1 to 4 carbon atoms, a hydroxyl group, a cyano group, and a hydroxyalkyl group having 1 to 10 carbon atoms.

Specific examples of the polyalicyclic hydrocarbon group include hydrocarbon groups including an alicyclic ring derived from a cycloalkane such as bicyclo[2.2.1]heptane, bicyclo[2.2.2]octane, tricyclo[5.2.1.0^{2,6}]decane, tetracyclo[6.2.1.1^{3,6}.0^{2,7}]dodecane, or tricycle[3.3.1.1^{3,7}]decane.

The alicyclic ring derived from a cycloalkane may be substituted with at least one linear, branched, or cyclic alkyl group having 1 to 4 carbon atoms, such as a methyl group, an ethyl group, an n-propyl group, an i-propyl group, an n-butyl group, a 2-methylpropyl group, a 1-methylpropyl group, or a t-butyl group, for example.

Note that the alicyclic ring derived from a cycloalkane may be substituted with a hydroxyl group, a cyano group, a hydroxyalkyl group having 1 to 10 carbon atoms, a carboxyl group, or oxygen.

Examples of a preferable monomer that produces the repeating unit (3) include bicyclo[2.2.1]heptyl (meth)acrylate, cyclohexyl (meth)acrylate, bicyclo[4.4.0]decanyl (meth)acrylate, bicyclo[2.2.2]octyl (meth)acrylate, tricyclo[5.2.1.0^{2,6}]decanyl (meth)acrylate, tetracyclo[6.2.1.1^{3,6}.0^{2,7}]dodecanyl (meth)acrylate, tricyclo[3.3.1.1^{3,7}]decanyl (meth)acrylate, and the like.

The resin (A) may include only one type of repeating unit (3), or may include two or more types of repeating unit (3).

In the general formula (4), it is preferable that at least one R⁹ represent a group other than a hydrogen atom, and at least one Y² represent a divalent organic group having 1 to 3 carbon atoms when Y¹ represents a single bond.

Examples of the divalent organic group having 1 to 3 carbon atoms represented by Y¹ and Y² in the general formula (4) include a methylene group, an ethylene group, and a propylene group.

Examples of the linear or branched alkyl group having 1 to 4 carbon atoms represented by R¹⁰ in the general formula (4) include a methyl group, an ethyl group, an n-propyl group, an i-propyl group, an n-butyl group, a 2-methylpropyl group, a 1-methylpropyl group, and a t-butyl group.

Examples of the alicyclic alkyl group having 3 to 20 carbon atoms represented by R¹⁰ include a cycloalkyl group shown by -CₙH₂ₙ₋₁ (wherein n is an integer from 3 to 20), a polyalicyclic alkyl group, and the like.

Examples of the cycloalkyl group include a cyclopropyl group, a cyclobutyl group, a cyclopentyl group, a cyclohexyl group, a cycloheptyl group, a cyclooctyl group, and the like.

Examples of the polyalicyclic alkyl group include a bicyclo[2.2.1]heptyl group, a tricyclo[5.2.1.0^{2,6}]decyl group, a tetracyclo[6.2.1^{3,6}.0^{2,7}]dodecanyl group, an adamantyl group, and the like.

The cycloalkyl group and the polyalicyclic alkyl group may be substituted with at least one linear, branched, or cyclic alkyl group.

Examples of a preferable monomer that produces the repeating unit (4) include 3-hydroxyadamant-1-yl (meth)acrylate, 3,5-dihydroxyadamant-yl (meth)acrylate, 3-hydroxyadamant-1-ylmethyl (meth)acrylate, methyl 3,5-dihydroxyadamant-1-yl (meth)acrylate, 3-hydroxy-5-methyladamant-1-yl (meth)acrylate, 3,5-dihydroxy-7-methyladamant-1-yl (meth)acrylate, 3-hydroxy-5,7-dimethyladamant-1-yl (meth)acrylate, 3-hydroxy-5,7-dimethyladamant-1-ylmethyl (meth)acrylate, and the like.

The resin (A) may include only one type of repeating unit (4), or may include two or more types of repeating unit (4).

The resin (A) may further include a repeating unit (hereinafter may be referred to as "additional repeating unit") other than the repeating units (1) to (4).

Examples of the additional repeating unit include units produced by cleavage of a polymerizable unsaturated bond of a polyfunctional monomer such as (meth)acrylates having a bridged hydrocarbon skeleton, such as dicyclopentenyl (meth)acrylate and adamantylmethyl (meth)acrylate; carboxyl group-containing esters having a bridged hydrocarbon skeleton of an unsaturated carboxylic acid, such as carboxynorbornyl (meth)acrylate, carboxytricyclodecanyl (meth)acrylate, and carboxytetracycloundecanyl (meth)acrylate;
(meth)acrylates that do not have a bridged hydrocarbon skeleton such as methyl (meth)acrylate, ethyl (meth)acrylate, n-propyl (meth)acrylate, n-butyl (meth)acrylate, 2-methylpropyl (meth)acrylate, 1-methylpropyl (meth)acrylate, t-butyl (meth)acrylate, 2-hydroxyethyl (meth)acrylate, 2-hydroxypropyl (meth)acrylate, 3-hydroxypropyl (meth)acrylate, cyclopropyl (meth)acrylate, cyclopentyl (meth)acrylate, cyclohexyl (meth)acrylate, 4-methoxycyclohexyl (meth)acrylate, 2-cyclopentyloxycarbonylethyl (meth)acrylate, 2-cyclohexyloxycarbonylethyl (meth)acrylate, and 2-(4-methoxycyclohexyl)oxycarbonylethyl (meth)acrylate;
(α-hydroxymethyl)acrylates such as methyl (α-hydroxymethyl)acrylate, ethyl (α-hydroxymethyl)acrylate, n-propyl (α-hydroxymethyl)acrylate, and n-butyl-(α-hydroxymethyl)acrylate; unsaturated nitrile compounds such as (meta)acrylonitrile, α-chloroacrylonitrile, crotonitrile, maleinitrile, fumarnitrile, mesaconitrile, citraconitrile, and itaconitrile; unsaturated amide compounds such as (meth)acrylamide, N,N-dimethyl (meth)acrylamide, crotonamide, maleinamide, fumaramide, mesaconamide, citraconamide, and itaconamide; other nitrogen-containing vinyl compounds such as N-(meth)acryloylmorpholine, N-vinyl-epsilon-caprolactam, N-vinylpyrrolidone, vinylpyridine, and vinylimidazole; unsaturated carboxylic acids (anhydrides) such as (meth)acrylic acid, crotonic acid, maleic acid, maleic anhydride, fumaric acid, itaconic acid, itaconic anhydride, citraconic acid, citraconic anhydride, and mesaconic acid; carboxyl group-containing esters that do not have a bridged hydrocarbon skeleton of an unsaturated carboxylic acid, such as 2-carboxyethyl (meth)acrylate, 2-carboxypropyl (meth)acrylate, 3-carboxypropyl (meth)acrylate, 4-carboxybutyl (meth)acrylate, and 4-carboxycyclohexyl (meth)acrylate;
polyfunctional monomers having a bridged hydrocarbon skeleton, such as 1,2-adamantanediol di(meth)acrylate, 1,3-adamantanediol di(meth)acrylate, 1,4-adamantanediol di(meth)acrylate, and tricyclodecanyl dimethylol di(meth)acrylate; and
polyfunctional monomers that do not have a bridged hydrocarbon skeleton, such as methylene glycol di(meth)acrylate, ethylene glycol di(meth)acrylate, propylene glycol di(meth)acrylate, 1,6-hexanediol di(meth)acrylate, 2,5-dimethyl-2,5-hexanediol di(meth)acrylate, 1,8-octanediol di(meth)acrylate, 1,9-nonanediol di(meth)acrylate, 1,4-bis(2-hydroxypropyl)benzene di(meth)acrylate, and 1,3-bis(2-hydroxypropyl)benzene di(meth)acrylate.

The resin (A) may include only one type of additional repeating unit, or may include two or more types of additional repeating unit.

The content of the repeating unit (a1) in the resin (A) is preferably 10 to 90 mol%, more preferably 20 to 80 mol%, and still more preferably 30 to 70 mol%, based on the total amount (=100 mol%) of the repeating units included in the resin (A). If the content of the repeating unit (a1) is 10 to 90 mol%, the developability, the defect resistance, the LWR, the PEB temperature dependence, and the like of the resulting resist can be improved. If the content of the repeating unit (a1) is less than 10 mol%, the developability, the LWR, and the PEB temperature dependence of the resulting resist may deteriorate. If the content of the repeating unit (a1) exceeds 90 mol%, the developability and the defect resistance of the resulting resist may deteriorate.

The content of the repeating unit (2) in the resin (A) is preferably 10 to 70 mol%, more preferably 15 to 65 mol%, and still more preferably 20 to 60 mol%, based on the total amount (=100 mol%) of the repeating units included in the resin (A). If the content of the repeating unit (2) is 10 to 70 mol%, the developability of the resulting resist can be improved. If the content of the repeating unit (2) is less than 10 mol%, the developability of the resulting resist may deteriorate. If the content of the repeating unit (2) exceeds 70 mol%, the solubility in a solvent or the developability of the resulting resist may deteriorate.

The content of the repeating unit (3) in the resin (A) is preferably 30 mol% or less, and more preferably 25 mol% or less, based on the total amount (=100 mol%) of the repeating units included in the resin (A). If the content of the repeating unit (3) exceeds 30 mol%, the resulting resist film may swell due to an alkaline developer, or the developability of the resulting resist may deteriorate.

The content of the repeating unit (4) in the resin (A) is preferably 30 mol% or less, and more preferably 25 mol% or less, based on the total amount (=100 mol%) of the repeating units included in the resin (A). If the content of the repeating unit (4) exceeds 30 mol%, the resulting resist film may swell due to an alkaline developer, or the developability of the resulting resist may deteriorate.

The content of the additional repeating unit in the resin (A) is preferably 50 mol% or less, and more preferably 40 mol% or less, based on the total amount (=100 mol%) of the repeating units included in the resin (A).

Since the resin (A) does not include a fluorine atom, the group included in each repeating unit (repeating units (1) to (4) and additional repeating unit) does not include a fluorine atom.

The resin (A) may be produced by an arbitrary method. For example, the resin (A) may be synthesized by radical polymerization or the like. The resin (A) is preferably synthesized by (1) polymerizing monomers while adding a reaction solution containing monomers and a radical initiator dropwise to a reaction solvent or a reaction solution containing monomers, (2) polymerizing monomers while adding a reaction solution containing monomers and a reaction solution containing a radical initiator dropwise to a reaction solvent or a reaction solution containing monomers, (3) polymerizing monomers while adding a plurality of reaction solutions respectively containing different types of monomers and a reaction solution containing a radical initiator dropwise to a reaction solvent or a reaction solution containing monomers, or the like.

The reaction temperature may be appropriately determined depending on the type of initiator, but is normally 30 to 180°C, for example. The reaction temperature is preferably 40 to 160°C, and more preferably 50 to 140°C.

The dropwise addition time may be appropriately determined depending on the reaction temperature, the type of initiator, and the type of monomer, but is preferably 30 minutes to 8 hours, more preferably 45 minutes to 6 hours, and still more preferably 1 to 5 hours.

The total reaction time including the dropwise addition time may be appropriately determined depending on the reaction temperature, the type of initiator, and the type of monomer, but is preferably 30 minutes to 8 hours, more preferably 45 minutes to 7 hours, and still more preferably 1 to 6 hours.

When adding a monomer solution dropwise to another monomer solution, the content of monomers in the monomer solution added to the other monomer solution is preferably 30 mol% or more, more preferably 50 mol% or more, and still preferably 70 mol% or more, based on the total amount of monomers subjected to polymerization.

Examples of the radical initiator used when polymerizing the resin (A) include 2,2'-azobis(4-methoxy-2,4-dimethylvaleronitrile), 2,2'-azobis(2-cyclopropylpropionitrile), 2,2'-azobis(2,4-dimethylvaleronitrile), 2,2'-azobis-iso-butylonitrile, 2,2'-azobis(2-methylbutyronitrile), 1,1'-azobis(cyclohexane-1-carbonitrile), 2,2'-azobis(2-methyl-N-phenylpropioneamidine)dihydrochloride, 2,2'-azobis(2-methyl-N-2-propenylpropioneamidine)dihydrochloride, 2,2'-azobis[2-(5-methyl-2-imidazolin-2-yl)propane]dihydrochloride, 2,2'-azobis{2-methyl-N-[1,1-bis(hydroxymethyl)-2-hydroxyethyl]propioneamide}, dimethyl-2,2'-azobis(2-methylpropionate), 4,4'-azobis(4-cyanovaleric acid), 2,2'-azobis(2-(hydroxymethyl)propionitrile), and the like. These radical initiators may be used either individually or in combination.

A solvent that dissolves the monomer and does not hinder polymerization may be used as the polymerization solvent. Examples of a solvent that hinders polymerization include a solvent that inhibits polymerization (e.g., nitrobenzene), a solvent that causes a chain transfer (e.g., mercapto compound), and the like.

Examples of a solvent that may suitably be used for polymerization include alcohols, ethers, ketones, amides, esters, lactones, nitriles, and a mixture thereof.

Examples of the alcohols include methanol, ethanol, propanol, isopropanol, butanol, ethylene glycol, propylene glycol, ethylene glycol monomethyl ether, ethylene glycol monoethyl ether, 1-methoxy-2-propanol, and the like.

Examples of the ethers include propyl ether, isopropyl ether, butyl methyl ether, tetrahydrofuran, 1,4-dioxane, 1,3-dioxolane, 1,3-dioxane, and the like.

Examples of the ketones include acetone, methyl ethyl ketone, diethyl ketone, methyl isopropyl ketone, methyl isobutyl ketone, and the like.

Examples of the amides include N,N-dimethylformamide, N,N-dimethylacetamide, and the like.

Examples of the esters and the lactones include ethyl acetate, methyl acetate, isobutyl acetate, γ-butyrolactone, and the like.

Examples of the nitriles include acetonitrile, propionitrile, butyronitrile, and the like.

These solvents may be used either individually or in combination.

The resin obtained by polymerization is preferably collected by re-precipitation. Specifically, the reaction solution is poured into a re-precipitation solvent after polymerization to collect the target resin as a powder.

Examples of the re-precipitation solvent include water, alcohols, ethers, ketones, amides, esters, lactones, nitriles, and a mixture thereof.

Examples of the alcohols include methanol, ethanol, propanol, isopropanol, butanol, ethylene glycol, propylene glycol, and 1-methoxy-2-propanol.

Examples of the ethers include propyl ether, isopropyl ether, butyl methyl ether, tetrahydrofuran, 1,4-dioxane, 1,3-dioxolane, and 1,3-dioxane.

Examples of the ketones include acetone, methyl ethyl ketone, diethyl ketone, methyl isopropyl ketone, methyl isobutyl ketone, and the like.

Examples of the amides include N,N-dimethylformamide, N,N-dimethylacetamide, and the like.

Examples of the esters and the lactones include ethyl acetate, methyl acetate, isobutyl acetate, γ-butyrolactone, and the like.

Examples of the nitriles include acetonitrile, propionitrile, butyronitrile, and the like.

The content of low-molecular-weight components derived from monomers in the resin (A) is preferably 0.1 mass% or less, more preferably 0.07 mass% or less, and particularly preferably 0.05 mass% or less, based on the total amount (100 mass%) of the resin (A). If the content of low-molecular-weight components is 0.1 mass% or less, it is possible to reduce the amount of eluate into water when performing liquid immersion lithography using a resist film produced using the resin (A). Moreover, it is possible to prevent a situation in which foreign matter is produced in the resist during storage, prevent non-uniform resist application, and sufficiently suppress occurrence of defects when forming a resist pattern.

The term "low-molecular-weight components derived from monomers" used herein refer to monomers, dimers, trimers, and oligomers having a polystyrene-reduced weight average molecular weight (hereinafter may be referred to as "Mw") determined by gel permeation chromatography (GPC) of 500 or less. Components having an Mw of 500 or less may be removed by chemical purification (e.g., washing with water or liquid-liquid extraction), or a combination of chemical purification and physical purification (e.g., ultrafiltration or centrifugation), for example.

The amount of low-molecular-weight components may be determined by analyzing the resin (A) by high-performance liquid chromatography (HPLC). It is preferable that the impurity (e.g., halogen and metal) content in the resin (A) be as low as possible. The sensitivity, the resolution, the process stability, the pattern shape, and the like of the resulting resist can be improved by reducing the impurity content in the resin (A).

The polystyrene-reduced weight average molecular weight (Mw) of the resin (A) determined by gel permeation chromatography (GPC) is not particularly limited, but is preferably 1000 to 100,000, more preferably 1000 to 30,000, and still more preferably 1000 to 20,000. If the Mw of the resin (A) is less than 1000, the heat resistance of the resulting resist may deteriorate. If the Mw of the resin (A) exceeds 100,000, the developability of the resulting resist may deteriorate.

The ratio (Mw/Mn) of the Mw to the polystyrene-reduced number average molecular weight (Mn) of the resin (A) determined by GPC is preferably 1.0 to 5.0, more preferably 1.0 to 3.0, and still more preferably 1.0 to 2.0.

The radiation-sensitive resin composition according to one embodiment of the invention may include only one type of resin (A), or may include two or more of types of resin (A).

### [1-2] Photoacid generator (B)

The photoacid generator (B) (hereinafter may be referred to as "acid generator (B)") generates an acid upon exposure. The acid generator causes dissociation of an acid-dissociable group of the resin (resin (A) and fluorine-containing resin (C)) included in the radiation-sensitive resin composition (elimination of a protective group) due to an acid generated upon exposure, so that the resin becomes alkali-soluble. As a result, the exposed area of the resist film becomes readily soluble in an alkaline developer. This makes it possible to form a positive-tone resist pattern.

The acid generator (B) preferably includes a compound shown by the following general formula (5). 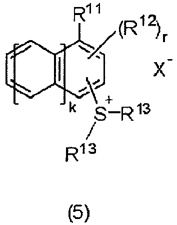 wherein R¹¹ represents a hydrogen atom, a fluorine atom, a hydroxyl group, a linear or branched alkyl group having 1 to 10 carbon atoms, a linear or branched alkoxy group having 1 to 10 carbon atoms, or a linear or branched alkoxycarbonyl group having 2 to 11 carbon atoms, R¹² represents a linear or branched alkyl group having 1 to 10 carbon atoms, a linear or branched alkoxy group having 1 to 10 carbon atoms, or a linear, branched, or cyclic alkanesulfonyl group having 1 to 10 carbon atoms, R¹³ individually represent a linear or branched alkyl group having 1 to 10 carbon atoms, a substituted or unsubstituted phenyl group, or a substituted or unsubstituted naphtyl group, or bond to each other to form a substituted or unsubstituted divalent group having 2 to 10 carbon atoms, k is an integer from 0 to 2, X⁻ represents an anion shown by R¹⁴CₙF₂ₙSO₃⁻ (wherein R¹⁴ represents a hydrogen atom, a fluorine atom, or a substituted or unsubstituted hydrocarbon group having 1 to 12 carbon atoms, and n is an integer from 1 to 10), an anion shown by R¹⁴SO³-, or an anion shown by the following general formula (6-1) or (6-2), and r is an integer from 1 to 10. 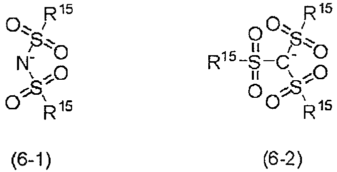 wherein R¹⁵ individually represent a linear or branched fluoroalkyl group having 1 to 10 carbon atoms, provided that two of R¹⁵ may bond to each other to form a substituted or unsubstituted divalent fluorine-containing group having 2 to 10 carbon atoms.

Examples of the linear or the branched alkyl group having 1 to 10 carbon atoms represented by R¹¹, R¹², and R¹³ in the general formula (5) include a methyl group, an ethyl group, an n-propyl group, an i-propyl group, an n-butyl group, a 2-methylpropyl group, a 1-methylpropyl group, a t-butyl group, an n-pentyl group, a neopentyl group, an n-hexyl group, an n-heptyl group, an n-octyl group, a 2-ethylhexyl group, an n-nonyl group, an n-decyl group, and the like. Among these, a methyl group, an ethyl group, an n-butyl group, a t-butyl group, and the like are preferable.

Examples of the linear or branched alkoxyl group having 1 to 10 carbon atoms represented by R¹¹ and R¹² include a methoxy group, an ethoxy group, an n-propoxy group, an i-propoxy group, an n-butoxy group, a 2-methylpropoxy group, a 1-methylpropoxy group, a t-butoxy group, an n-pentyloxy group, a neopentyloxy group, an n-hexyloxy group, an n-heptyloxy group, an n-octyloxy group, a 2-ethylhexyloxy group, an n-nonyloxy group, an n-decyloxy group, and the like. Among these, a methoxy group, an ethoxy group, an n-propoxy group, a n-butoxy group, and the like are preferable.

Examples of the linear or branched alkoxycarbonyl group having 2 to 11 carbon atoms represented by R¹¹ include a methoxycarbonyl group, an ethoxycarbonyl group, an n-propoxycarbonyl group, an i-propoxycarbonyl group, an n-butoxycarbonyl group, a 2-methylpropoxycarbonyl group, an 1-methylpropoxycarbonyl group, a t-butoxycarbonyl group, an n-pentyloxycarbonyl group, a neopentyloxycarbonyl group, an n-hexyloxycarbonyl group, an n-heptyloxycarbonyl group, an n-octyloxycarbonyl group, a 2-ethylhexyloxycarbonyl group, an n-nonyloxycarbonyl group, an n-decyloxycarbonyl group, and the like. Among these, a methoxycarbonyl group, an ethoxycarbonyl group, an n-butoxycarbonyl group, and the like are preferable.

Examples of the linear, branched, or cyclic alkanesulfonyl group having 1 to 10 carbon atoms represented by R¹² include a methanesulfonyl group, an ethanesulfonyl group, an n-propanesulfonyl group, an n-buthanesulfonyl group, a tert-butanesulfonyl group, an n-pentanesulfonyl group, a neopentanesulfonyl group, an n-hexanesulfonyl group, an n-heptanesulfonyl group, an n-octanesulfonyl group, a 2-ethylhexanesulfonyl group, an n-nonanesulfonyl group, an n-decanesulfonyl group, a cyclopentanesulfonyl group, a cyclohexanesulfonyl group, and the like. Among these, a methanesylfonyl group, an ethanesulfonyl group, an n-propanesulfonyl group, an n-butanesulfonyl group, a cyclopentansulfonyl group, a cyclohexanesulfonyl group, and the like are preferable.

r in the general formula (5) is an integer from 0 to 10, and preferably an integer from 0 to 2.

Examples of the substituted or unsubstituted phenyl group represented by R¹³ in the general formula (5) include a phenyl group; a phenyl group substituted with a linear, branched, or cyclic alkyl group having 1 to 10 carbon atoms, such as an o-tolyl group, an m-tolyl group, a p-tolyl group, a 2,3-dimethylphenyl group, a 2,4-dimethylphenyl group, a 2,5-dimethylphenyl group, a 2,6-dimethylphenyl group, a 3,4-dimethylphenyl group, a 3,5-dimethylphenyl group, a 2,4,6-trimethylphenyl group, a 4-ethylphenyl group, a 4-t-butylphenyl group, a 4-cyclohexylphenyl group, or a 4-fluorophenyl group; a group obtained by substituting a phenyl group or the alkyl-substituted phenyl group with at least one group selected from a hydroxyl group, a carboxyl group, a cyano group, a nitro group, an alkoxy group, an alkoxyalkyl group, an alkoxycarbonyl group, and an alkoxycarbonyloxy group; and the like.

Examples of the alkoxy group as a substituent for a phenyl group or the alkyl-substituted phenyl group include linear, branched, or cyclic alkoxy groups having 1 to 20 carbon atoms, such as a methoxy group, an ethoxy group, an n-propoxy group, an i-propoxy group, an n-butoxy group, a 2-methylpropoxy group, a 1-methylpropoxy group, a t-butoxy group, a cyclopentyloxy group, and a cyclohexyloxy group, and the like.

Examples of the alkoxyalkyl group include linear, branched, or cyclic alkoxyalkyl groups having 2 to 21 carbon atoms, such as a methoxymethyl group, an ethoxymethyl group, a 1-methoxyethyl group, a 2-methoxyethyl group, a 1-ethoxyethyl group, and a 2-ethoxyethyl group, and the like.

Examples of the alkoxycarbonyl group include linear, branched, or cyclic alkoxycarbonyl groups having 2 to 21 carbon atoms, such as a methoxycarbonyl group, an ethoxycarbonyl group, an n-propoxycarbonyl group, an i-propoxycarbonyl group, an n-butoxycarbonyl group, a 2-methylpropoxycarbonyl group, a 1-methylpropoxycarbonyl group, a t-butoxycarbonyl group, a cyclopentyloxycarbonyl group, and a cyclohexyloxycarbonyl group, and the like.

Examples of the alkoxycarbonyloxy group include linear, branched, or cyclic alkoxycarbonyloxy groups having 2 to 21 carbon atoms, such as a methoxycarbonyloxy group, an ethoxycarbonyloxy group, an n-propoxycarbonyloxy group, an i-propoxycarbonyloxy group, an n-butoxycarbonyloxy group, a t-butoxycarbonyloxy group, a cyclopentyloxycarbonyl group, and a cyclohexyloxycarbonyl group, and the like.

Among the above substituted or unsubstituted phenyl groups, a phenyl group, a 4-cyclohexylphenyl group, a 4-t-butylphenyl group, a 4-methoxyphenyl group, a 4-t-butoxyphenyl group, and the like are preferable.

Examples of the substituted or unsubstituted naphthyl group represented by R¹³ include a naphthyl group (e.g., 1-naphthyl group); naphthyl groups substituted with a linear, branched, or cyclic alkyl group having 1 to 10 carbon atoms, such as a 2-methyl-1-naphthyl group, a 3-methyl-1-naphthyl group, a 4-methyl-1-naphthyl group, a 5-methyl-1-naphthyl group, a 6-methyl-1-naphthyl group, a 7-methyl-1-naphthyl group, a 8-methyl-1-naphthyl group, a 2,3-dimethyl-1-naphthyl group, a 2,4-dimethyl-1-naphthyl group, a 2,5-dimethyl-1-naphthyl group, a 2,6-dimethyl-1-naphthyl group, a 2,7-dimethyl-1-naphthyl group, a 2,8-dimethyl-1-naphthyl group, a 3,4-dimethyl-1-naphthyl group, a 3,5-dimethyl-1-naphthyl group, a 3,6-dimethyl-1-naphthyl group, a 3,7-dimethyl-1-naphthyl group, a 3,8-dimethyl-1-naphthyl group, a 4,5-dimethyl-1-naphthyl group, a 5,8-dimethyl-1-naphthyl group, a 4-ethyl-1-naphthyl group, a 2-naphthyl group, a 1-methyl-2-naphthyl group, a 3-methyl-2-naphthyl group, and a 4-methyl-2-naphthyl group; a group obtained by substituting a naphthyl group or the alkyl-substituted naphthyl group with at least one group selected from a hydroxyl group, a carboxyl group, a cyano group, a nitro group, an alkoxy group, an alkoxyalkyl group, an alkoxycarbonyl group, and an alkoxycarbonyloxy group; and the like.

Examples of the alkoxy group, the alkoxyalkyl group, the alkoxycarbonyl group, and the alkoxycarbonyloxy group as a substituent for a naphthyl group or the alkyl-substituted naphthyl group include the groups mentioned above in connection with a phenyl group and the alkyl-substituted phenyl group.

Among the above substituted or unsubstituted naphthyl groups, a 1-naphthyl group, a 1-(4-methoxynaphthyl) group, a 1-(4-ethoxynaphthyl) group, a 1-(4-n-propoxynaphthyl) group, a 1-(4-n-butoxynaphthyl) group, a 2-(7-methoxynaphthyl) group, a 2-(7-ethoxynaphthyl) group, a 2-(7-n-propoxynaphthyl) group, a 2-(7-n-butoxynaphthyl) group, and the like are preferable.

The divalent group having 2 to 10 carbon atoms formed when two R¹³ bond to each other is preferably a group that forms a five or six-membered ring (particularly preferably a five-membered ring (i.e., tetrahydrothiophene ring)) together with the sulfur atom of the general formula (5).

Examples of a substituent for the divalent group include the groups (e.g., hydroxyl group, carboxyl group, cyano group, nitro group, alkoxyl group, alkoxyalkyl group, alkoxycarbonyl group, and alkoxycarbonyloxy group) mentioned above in connection with a phenyl group and the alkyl-substituted phenyl group.

It is preferable that R¹³ in the general formula (5) represent a methyl group, an ethyl group, a phenyl group, a 4-methoxyphenyl group, or a 1-naphthyl group, or two of R¹³ bond to each other to form a divalent group having a tetrahydrothiophene ring structure together with the sulfur atom, for example.

Examples of a preferable cation moiety in the general formula (5) include a triphenylsulfonium cation, a tri-1-naphthylsulfonium cation, a tri-tert-butylphenylsulfonium cation, a 4-fluorophenyldiphenylsulfonium cation, a di-4-fluorophenylphenylsulfonium cation, a tri-4-fluorophenylsulfonium cation, a 4-cyclohexylphenyldiphenylsulfonium cation, a 4-methanesulfonylphenyldiphenylsulfonium cation, a 4-cyclohexanesulfonyldiphenylsulfonium cation, a 1-naphthyldimethylsulfonium cation, a 1-naphthyldiethylsulfonium cation,
a 1-(4-hydroxynaphthalen-1-yl)dimethylsulfonium cation, a 1-(4-methylnaphthalen-1-yl)dimethylsulfonium cation, a 1-(4-methylnaphthalen-1-yl)diethylsulfonium cation, a 1-(4-cyanonaphthalen-1-yl)dimethylsulfonium cation, a 1-(4-cyanonaphthalen-1-yl)diethylsulfonium cation, a 1-(3,5-dimethyl-4-hydroxyphenyl)tetrahydrothiophenium cation, a 1-(4-methoxynaphthalen-1-yl)tetrahydrothiophenium cation, a 1-(4-ethoxynaphthalen-1-yl)tetrahydrothiophenium cation, a 1-(4-n-propoxynaphthalen-1-yl)tetrahydrothiophenium cation, a 1-(4-n-butoxynaphthalen-1-yl)tetrahydrothiophenium cation, a 2-(7-methoxynaphthalen-2-yl)tetrahydrothiophenium cation, a 2-(7-ethoxynaphthalen-2-yl)tetrahydrothiophenium cation, a 2-(7-n-propoxynaphthalen-2-yl) tetrahydrothiophenium cation, a 2-(7-n-butoxynaphthalen-2-yl)tetrahydrothiophenium cation, and the like.

The CₙF₂ₙ⁻ group in the R¹⁴CₙF₂ₙSO₃⁻ anion represented by X⁻ in the general formula (5) is a perfluoroalkyl group having n carbon atoms. This group may be either linear or branched. n is preferably 1, 2, 4, or 8.

The substituted or unsubstituted hydrocarbon group having 1 to 12 carbon atoms represented by R¹⁴ in the R¹⁴CₙF₂ₙSO₃⁻ anion and the R¹⁴SO₃⁻ anion is preferably an alkyl group having 1 to 12 carbon atoms, a cycloalkyl group, or a bridged alicyclic hydrocarbon group. Specific examples of the hydrocarbon group having 1 to 12 carbon atoms represented by R¹⁴ include a methyl group, an ethyl group, an n-propyl group, an i-propyl group, an n-butyl group, a 2-methylpropyl group, a 1-methylpropyl group, a t-butyl group, an n-pentyl group, an neopentyl group, an n-hexyl group, a cyclohexyl group, an n-heptyl group, an n-octyl group, a 2-ethylhexyl group, an n-nonyl group, an n-decyl group, a norbornyl group, a norbornylmethyl group, a hydroxynorbornyl group, an adamantyl group, and the like.

Examples of the fluoroalkyl group having 1 to 10 carbon atoms represented by R¹⁵ in the general formulas (6-1) and (6-2) include a trifluoromethyl group, a pentafluoroethyl group, a heptafuluoropropyl group, a nonafluorobutyl group, a dodecafluoropentyl group, a perfluorooctyl group, and the like.

Examples of the divalent fluorine-containing group having 2 to 10 carbon atoms formed when two R¹⁵ in the general formulas (6-1) and (6-2) bond to each other include a tetrafluoroethylene group, a hexafluoropropylene group, an octafluorobutylene group, a decafluoropentylene group, an undecafluorohexylene group, and the like.

Examples of a preferable anion moiety in the general formula (5) include a trifluoromethanesulfonate anion, a perfluoro-n-butanesulfonate anion, a perfluoro-n-octanesulfonate anion, a 2-bicyclo[2.2.1]hept-2-yl-1,1,2,2-tetrafluoroethanesulfonate anion, a 2-bicyclo[2.2.1]hept-2-yl-1,1-difluoroethanesulfonate anion, a 1-adamantylsulfonate anion, anions shown by the following formulas (7-1) to (7-7), and the like.

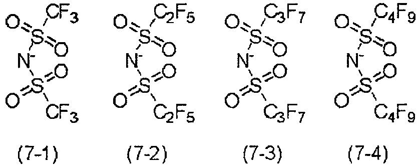

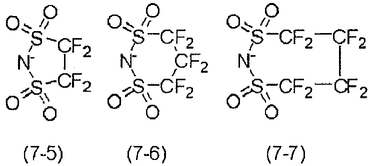

The acid generator (B) includes the above cation and anion in an arbitrary combination.

Note that the acid generator (B) shown by the general formula (5) excludes a photoacid generator that includes a 1-(3,5-dimethyl-4-hydroxyphenyl)tetrahydrothiophenium cation, a 1-(4-methoxynaphthalen-1-yl)tetrahydrothiophenium cation, a 1-(4-ethoxynaphthalen-1-yl)tetrahydrothiophenium cation, a 1-(4-n-propoxynaphthalen-1-yl)tetrahydrothiophenium cation, a 1-(4-n-butoxynaphthalen-1-yl)tetrahydrothiophenium cation, a 2-(7-methoxynaphthalen-2-yl)tetrahydrothiophenium cation, a 2-(7-ethoxynaphthalen-2-yl)tetrahydrothiophenium cation, a 2-(7-n-propoxynaphthalen-2-yl)tetrahydrothiophenium cation, or a 2-(7-n-butoxynaphthalen-2-yl)tetrahydrothiophenium cation, and a trifluoromethanesulfonate anion, a perfluoro-n-butanesulfonate anion, or a perfluoro-n-octanesulfonate anion.

An acid generator other than the acid generator shown by the general formula (5) (hereinafter referred to as "additional acid generator") (e.g., onium salt compounds, halogen-containing compounds, diazoketone compounds, sulfone compounds, and sulfonic acid compounds) may also be used as the acid generator (B).

Examples of the onium salt compounds include iodonium salts, sulfonium salts, phosphonium salts, diazonium salts, pyridinium salts, and the like. Specific examples of the onium salt compounds include diphenyliodonium trifluoromethanesulfonate, diphenyliodonium nonafluoro-n-butanesulfonate, diphenyliodonium perfluoro-n-octanesulfonate, diphenyliodonium 2-bicyclo[2.2.1]hept-2-yl-1,1,2,2-tetrafluoroethanesulfonate, bis(4-t-butylphenyl)iodonium trifluoromethanesulfonate, bis(4-t-butylphenyl)iodonium nonafluoro-n-butanesulfonate, bis(4-t-butylphenyl)iodonium perfluoro-n-octanesulfonate, bis(4-t-butylphenyl)iodonium 2-bicyclo[2.2.1]hept-2-yl-1,1,2,2-tetrafluoroethanesulfonate, cyclohexyl·2-oxocyclohexyl·methylsulfonium trifluoromethanesulfonate, dicyclohexyl·2-oxocyclohexylsulfonium trifluoromethanesulfonate, 2-oxocyclohexyldimethylsulfonium trifluoromethanesulfonate, and the like.

Examples of the halogen-containing compounds include haloalkyl group-containing hydrocarbon compounds, haloalkyl group-containing heterocyclic compounds, and the like. Specific examples of the halogen-containing compounds include (trichloromethyl)-s-triazine derivatives such as phenylbis(trichloromethyl)-s-triazine, 4-methoxyphenylbis(trichloromethyl)-s-triazine, 1-naphthylbis(trichloromethyl)-s-triazine, 1,1-bis(4-chlorophenyl)-2,2,2-trichloroethane, and the like.

Examples of the diazoketone compounds include 1,3-diketo-2-diazo compounds, diazobenzoquinone compounds, diazonaphthoquinone compounds, and the like. Specific examples of the diazoketone compounds include 1,2-naphthoquinonediazido-4-sulfonyl chloride, 1,2-naphthoquinonediazido-5-sulfonyl chloride, 1,2-naphthoquinonediazido-4-sulfonate or 1,2-naphthoquinonediazido-5-sulfonate of 2,3,4,4'-tetrahydroxybenzophenone, 1,2-naphthoquinonediazido-4-sulfonate or 1,2-naphthoquinonediazido-5-sulfonate of 1,1,1-tris(4-hydroxyphenyl)ethane, and the like.

Examples of the sulfone compounds include β-ketosulfone, β-sulfonylsulfone, α-diazo compounds thereof, and the like. Specific examples of the sulfone compounds include 4-trisphenacylsulfone, mesitylphenacylsulfone, bis(phenylsulfonyl)methane, and the like.

Examples of the sulfonic acid compounds include alkyl sulfonates, alkylimide sulfonates, haloalkyl sulfonates, aryl sulfonates, imino sulfonates, and the like. Specific examples of the sulfonic acid compounds include benzointosylate, tris(trifluoromethanesulfonate) of pyrogallol, nitrobenzyl-9,10-diethoxyanthracene-2-sulfonate, trifluoromethanesulfonylbicyclo[2.2.1]hept-5-ene-2,3-dicarbodiimide, nonafluoro-n-butanesulfonylbicyclo[2.2.1]hept-5-ene-2,3-dicarbodiimide, perfluoro-n-octanesulfonylbicyclo[2.2.1]hept-5-ene-2,3-dicarbodiimide, 2-bicyclo[2.2.1]hept-2-yl-1,1,2,2-tetrafluoroethanesulfonylbicyclo[2.2.1]hept-5-ene-2,3-dicarbodiimide, N-(trifluoromethanesulfonyloxy)succinimide, N-(nonafluoro-n-butanesulfonyloxy)succinimide, N-(perfluoro-n-octanesulfonyloxy)succinimide, N-(2-bicyclo[2.2.1]hept-2-yl-1,1,2,2-tetrafluoroethanesulfonyloxy)succinimide, 1,8-naphthalenedicarboxylic acid imide trifluoromethanesulfonate, 1,8-naphthalenedicarboxylic acid imide nonafluoro-n-butanesulfonate, 1,8-naphthalenedicarboxylic acid imide perfluoro-n-octanesulfonate, and the like.

These acid generators (B) may be used either individually or in combination.

The content of the acid generator (B) in the radiation-sensitive resin composition according to one embodiment of the invention is preferably 0.1 to 20 parts by mass, and more preferably 0.5 to 15 parts by mass, based on 100 parts by mass of the resin (A), so that the resulting resist exhibits sufficient sensitivity and developability. If the content of the acid generator (B) is less than 0.1 parts by mass, the resulting resist may exhibit insufficient sensitivity and insufficient developability. If the content of the acid generator (B) exceeds 20 parts by mass, a rectangular resist pattern may not be obtained due to a decrease in radiation transmittance.

When using the additional acid generator, the content of the additional acid generator in the radiation-sensitive resin composition is preferably 80 mass% or less, and more preferably 60 mass% or less, based on the total amount (=100 mass%) of the acid generator (B).

### [1-3] Fluorine-containing resin (C)

The fluorine-containing resin (C) includes a repeating unit that becomes alkali-soluble due to an acid, and a fluorine-containing repeating unit. Specifically, the fluorine-containing resin (C) is insoluble or scarcely soluble in alkali, but becomes alkali-soluble due to an acid, and includes a fluorine atom. The expression "insoluble or scarcely soluble in alkali" used herein means that a film that is formed only of the fluorine-containing resin (C) has a thickness equal to or more than 50% of the initial thickness when developed under alkaline development conditions employed when forming a resist pattern using a photoresist film that is formed of a radiation-sensitive resin composition that includes the fluorine-containing resin (C).

The fluorine-containing resin (C) provides the surface of the resist film with water repellency during liquid immersion lithography. The fluorine-containing resin (C) thus suppresses elution of components from the resist film into an immersion liquid, and makes it possible to implement liquid immersion lithography by a high-speed scan without causing droplets to remain. Therefore, defects (e.g., watermark defect) that may occur due to liquid immersion lithography can be suppressed.

The description given above in connection with the repeating unit (a1) included in the resin (A) may be applied to the repeating unit that is included in the fluorine-containing resin (C) and becomes alkali-soluble due to an acid (hereinafter may be referred to as "repeating unit (a2)").

The repeating unit (a2) included in the fluorine-containing resin (C) is preferably a repeating unit that includes any of the groups shown by the general formulas (1a) to (1d), and more preferably a repeating unit that includes the group shown by the general formulas (1c) (see the following general formula (1c-1)). 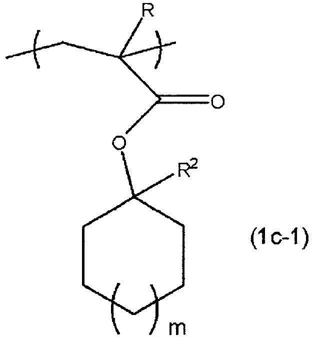 wherein R represents a hydrogen atom, an alkyl group having 1 to 4 carbon atoms, a trifluoromethyl group, or a hydroxymethyl group, R² represents a linear or branched alkyl group having 1 to 4 carbon atoms, and m is an integer from 0 to 4.

Examples of the linear or branched alkyl group having 1 to 4 carbon atoms represented by R and R² in the general formula (1c-1) include a methyl group, an ethyl group, an n-propyl group, an i-propyl group, an n-butyl group, a 2-methylpropyl group, a 1-methylpropyl group, a t-butyl group, and the like.

m in the general formula (1c-1) is an integer from 0 to 4, and preferably an integer from 0 to 3.

The fluorine-containing resin (C) preferably includes at least one of a repeating unit shown by the following general formula (8) (hereinafter referred to as "repeating unit (8)") and a repeating unit shown by the following general formula (9) (hereinafter referred to as "repeating unit (9)") as the fluorine-containing repeating unit. 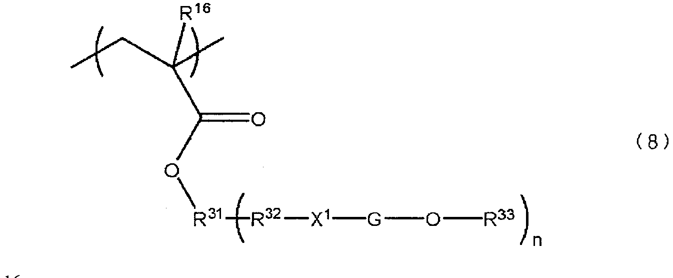 wherein R¹⁶ represents a hydrogen atom, an alkyl group having 1 to 4 carbon atoms, a trifluoromethyl group, or a hydroxymethyl group, R³¹ represents a single bond or an (n+1)-valent chain-like or cyclic hydrocarbon group, R³² individually represents a single bond or a divalent chain-like or cyclic hydrocarbon group, X¹ represents a methylene group substituted with a fluorine atom, or a linear or branched fluoroalkylene group having 2 to 20 carbon atoms, G represents a single bond or -CO-, n is an integer from 1 to 3, and and R³³ represents a hydrogen atom or an acid-dissociable group. 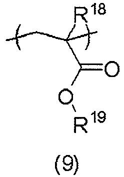 wherein R¹⁸ individually represent a hydrogen atom, an alkyl group having 1 to 4 carbon atoms, a trifluoromethyl group, or a hydroxymethyl group, and R¹⁹ represents a linear, branched, or cyclic alkyl group having 1 to 12 carbon atoms in which at least one hydrogen atom is substituted with a fluorine atom.

Examples of the alkyl group having 1 to 4 carbon atoms represented by R¹⁶ and R¹⁸ in the general formulas (8) and (9) include a methyl group, an ethyl group, an n-propyl group, an i-propyl group, an n-butyl group, a 2-methylpropyl group, a 1-methylpropyl group, a t-butyl group, and the like.

The (n+1)-valent chain-like or cyclic hydrocarbon group represented by R³¹ in the general formula (8) may be either a saturated hydrocarbon group or an unsaturated hydrocarbon group, and preferably has 1 to 10 carbon atoms.

Examples of the linear or branched saturated or unsaturated divalent (n=1) hydrocarbon group represented by R³¹ include divalent hydrocarbon groups derived from a linear or branched alkyl group having 1 to 10 carbon atoms (e.g., methyl group, ethyl group, n-propyl group, i-propyl group, n-butyl group, 2-methylpropyl group, 1-methylpropyl group, t-butyl group, pentyl group, isopentyl group, neopentyl group, hexyl group, heptyl group, octyl group, nonyl group, and decyl group), and the like.

Examples of the cyclic saturated or unsaturated divalent (n=1) hydrocarbon group represented by R³¹ include groups derived from an alicyclic hydrocarbon or an aromatic hydrocarbon having 3 to 10 carbon atoms.

Examples of the alicyclic hydrocarbon include cycloalkanes such as cyclobutane, cyclopentane, cyclohexane, bicyclo[2.2.1]heptane, bicyclo[2.2.2]octane, tricyclo[5.2.1.0^{2,6}]decane, and tricyclo[3.3.1.1^{3,7}]decane, and the like.

Examples of the aromatic hydrocarbon include benzene, naphthalene, and the like.

The hydrocarbon group represented by R³¹ may be a group obtained by substituting at least one hydrogen atom of the unsubstituted hydrocarbon group with at least one of a linear, branched, or cyclic alkyl group having 1 to 4 carbon atoms, such as a methyl group, an ethyl group, an n-propyl group, an i-propyl group, an n-butyl group, a 2-methylpropyl group, a 1-methylpropyl group, or a t-butyl group, a hydroxyl group, a cyano group, a hydroxyalkyl group having 1 to 10 carbon atoms, a carboxyl group, an oxygen atom, and the like.

Examples of the trivalent (n=2) hydrocarbon group represented by R³¹ include groups obtained by elimination of one hydrogen atom from the above divalent hydrocarbon group. Examples of the tetravalent (n=3) hydrocarbon group represented by R³¹ include groups obtained by elimination of two hydrogen atoms from the above divalent hydrocarbon group.

The divalent chain-like or cyclic hydrocarbon group represented by R³² in the general formula (8) may be either a saturated hydrocarbon group or an unsaturated hydrocarbon group, and preferably has 1 to 20 carbon atoms.

Examples of the divalent chain-like or cyclic hydrocarbon group include divalent hydrocarbon groups derived from an alkyl group (e.g., methyl group, ethyl group, n-propyl group, i-propyl group, n-butyl group, 2-methylpropyl group, 1-methylpropyl group, t-butyl group, pentyl group, isopentyl group, neopentyl group, hexyl group, heptyl group, octyl group, nonyl group, and decyl group), an alkylene glycol group, an alkylene ester group, and the like.

The hydrocarbon group represented by R³² may be a group obtained by substituting at least one hydrogen atom of the unsubstituted hydrocarbon group with at least one of a linear, branched, or cyclic alkyl group having 1 to 4 carbon atoms, such as a methyl group, an ethyl group, an n-propyl group, an i-propyl group, an n-butyl group, a 2-methylpropyl group, a 1-methylpropyl group, or a t-butyl group, a hydroxyl group, a cyano group, a hydroxyalkyl group having 1 to 10 carbon atoms, a carboxyl group, an oxygen atom, and the like.

Specific examples of the divalent chain-like or cyclic hydrocarbon group represented by R³² include unsaturated linear hydrocarbon groups such as a methylene group, an ethylene group, a propylene group (e.g., 1,3-propylene group and 1,2- propylene group), a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, an icosylene group, a 1-methyl-1,3-propylene group, a 2-methyl-1,3-propylene group, a 2-methyl-1,2-propylene group, a 1-methyl-1,4-butylene group, a 2-methyl-1,4-butylene group, a methylidene group, an ethylidene group, a propylidene group, and a 2-propylidene group; monocyclic hydrocarbon groups such as cycloalkylene groups having 3 to 10 carbon atoms such as a cyclobutylene group (e.g., 1,3-cyclobutylene group), a cyclopentylene group (e.g., 1,3-cyclopentylene group), a cyclohexylene group (e.g., 1,4-cyclohexylene group), and a cyclooctylene group (e.g., 1,5-cyclooctylene group); bridged cyclic hydrocarbon groups such as dicyclic, tricyclic, or tetracyclic hydrocarbon groups having 4 to 30 carbon atoms such as a norbornylene group (e.g., 1,4-norbornylene group and 2,5-norbornylene group), and an admantylene group (e.g., 1,5-admantylene group and 2,6-admantylene group); and the like.

When n in the general formula (8) is 2 or 3, the groups represented by R³² may be either the same or different.

The acid-dissociable group represented by R³³ in the general formula (8) refers to a group that substitutes a hydrogen atom of an acidic functional group such as a hydroxyl group, a carboxyl group, or a sulfonic acid group, and dissociates in the presence of an acid.

Examples of the acid-dissociable group include a t-butoxycarbonyl group, a tetrahydropyranyl group, a tetrahydrofuranyl group, a (thiotetrahydropyranylsulfanyl)methyl group, a (thiotetrahydrofuranylsulfanyl)methyl group, an alkoxy-substituted methyl group, an alkylsulfanyl-substituted methyl group, and the like.

Examples of the alkoxy group (substituent) for the alkoxy-substituted methyl group include alkoxy groups having 1 to 4 carbon atoms. Examples of the alkyl group (substituent) for the alkylsulfanyl-substituted methyl group include alkyl groups having 1 to 4 carbon atoms.

Further examples of the acid-dissociable group include a group shown by the general formula "-C(R)₃" (wherein R individually represent a linear or branched alkyl group having 1 to 4 carbon atoms, a monovalent alicyclic hydrocarbon group having 4 to 20 carbon atoms, or a group derived therefrom, or two of R bond to form a divalent alicyclic hydrocarbon group having 4 to 20 carbon atoms, or a group derived therefrom, together with a carbon atom bonded thereto, and the remaining R represents a linear or branched alkyl group having 1 to 4 carbon atoms, a monovalent alicyclic hydrocarbon group having 4 to 20 carbon atoms, or a group derived therefrom).

Examples of the linear or branched alkyl group having 1 to 4 carbon atoms represented by R in the acid-dissociable group shown by the general formula "-C(R)₃" include a methyl group, an ethyl group, an n-propyl group, an i-propyl group, an n-butyl group, a 2-methylpropyl group, a 1-methylpropyl group, a t-butyl group, and the like.

Examples of the monovalent alicyclic hydrocarbon group having 4 to 20 carbon atoms represented by R include a group that includes an alicyclic ring derived from a cycloalkane (e.g., norbornane, tricyclodecane, tetracyclododecane, adamantane, cyclobutane, cyclopentane, cyclohexane, cycloheptane, or cyclooctane), and the like.

Examples of a group derived from the alicyclic hydrocarbon group include a group obtained by substituting the monovalent alicyclic hydrocarbon group with at least one linear, branched, or cyclic alkyl group having 1 to 4 carbon atoms, such as a methyl group, an ethyl group, an n-propyl group, an i-propyl group, an n-butyl group, a 2-methylpropyl group, a 1-methylpropyl group, or a t-butyl group, and the like.

Among these, an alicyclic hydrocarbon group that includes an alicyclic ring derived from norbornane, tricyclodecane, tetracyclododecane, adamantane, cyclopentane, or cyclohexane, a group obtained by substituting the alicyclic hydrocarbon group with the above alkyl group, and the like are preferable.

Examples of the divalent alicyclic hydrocarbon group having 4 to 20 carbon atoms that is formed by two of R together with the carbon atom that is bonded thereto (i.e., the carbon atom bonded to the oxygen atom) include monocyclic hydrocarbon groups such as a cyclobutylene group, a cyclopentylene group, a cyclohexylene group, and a cyclooctylene group, polycyclic hydrocarbon groups such as a norbornylane group, a tricyclodecanylene group, and a tetracyclodecanylene group, and bridged polycyclic hydrocarbon groups such as an adamantylene group.

Examples of a group derived from the divalent alicyclic hydrocarbon group formed by two of R include a group obtained by substituting the divalent alicyclic hydrocarbon group with at least one linear, branched, or cyclic alkyl group having 1 to 4 carbon atoms, such as a methyl group, an ethyl group, an n-propyl group, an i-propyl group, an n-butyl group, a 2-methylpropyl group, a 1-methylpropyl group, or a t-butyl group, and the like.

Among these, monocyclic hydrocarbon groups such as a cyclopentylene group and a cyclohexylene group, a group obtained by substituting the divalent alicyclic hydrocarbon group (monocyclic hydrocarbon group) with any of the above alkyl groups, and the like are preferable.

Examples of a preferable acid-dissociable group shown by the general formula "-C(R)₃" include a t-butyl group, a 1-n-(1-ethyl-1-methyl)propyl group, a 1-n-(1,1-dimethyl)propyl group, a 1-n-(1,1-dimethyl)butyl group, a 1-n-(1,1-dimethyl)pentyl group, 1-(1,1-diethyl)propyl group, a 1-n-(1,1-diethyl)butyl group, a 1-n-(1,1-diethyl)pentyl group, a 1-(1-methyl)cyclopentyl group, a 1-(1-ethyl)cyclopentyl group, a 1-(1-n-propyl)cyclopentyl group, a 1-(1-i-propyl)cyclopentyl group, a 1-(1-methyl)cyclohexyl group, a 1-(1-ethyl)cyclohexyl group, a 1-(1-n-propyl)cyclohexyl group, a 1-(1-i-propyl)cyclohexyl group, a 1-{1-methyl-1-(2-norbornyl)}ethyl group, a 1-{1-methyl-1-(2-tetracyclodecanyl)}ethyl group, a 1-{1-methyl-1-(1-adamantyl)}ethyl group, a 2-(2-methyl)norbornyl group, a 2-(2-ethyl)norbornyl group, a 2-(2-n-propyl)norbornyl group, a 2-(2-i-propyl)norbornyl group, a 2-(2-methyl)tetracyclodecanyl group, a 2-(2-ethyl)tetracyclodecanyl group, a 2-(2-n-propyl)tetracyclodecanyl group, a 2-(2-i-propyl)tetracyclodecanyl group, a 1-(1-methyl)adamantyl group, a 1-(1-ethyl)adamantyl group, a 1-(1-n-propyl)adamantyl group, a 1-(1-i-propyl)adamantyl group, groups obtained by substituting these groups with at least one linear, branched, or cyclic alkyl group having 1 to 4 carbon atoms, such as a methyl group, an ethyl group, a n-propyl group, an i-propyl group, an n-butyl group, a 2-methylpropyl group, a 1-methylpropyl group, or a t-butyl group, and the like.

Among these, the group shown by the general formula "-C(R)₃", a t-butoxycarbonyl group, an alkoxy-substituted methyl group, and the like are preferable. In particular, a t-butoxycarbonyl group or an alkoxy-substituted methyl group is preferable when protecting a hydroxyl group, and the group shown by the general formula "-C(R)₃" is preferable when protecting a carboxyl group.

Examples of the methylene group substituted with a fluorine atom or the linear or branched fluoroalkylene group having 2 to 20 carbon atoms represented by X¹ in the general formula (8) include structures shown by the following formulas (X-1) to (X-8), and the like.

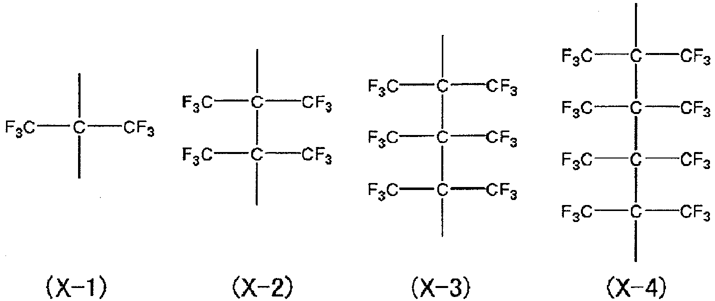

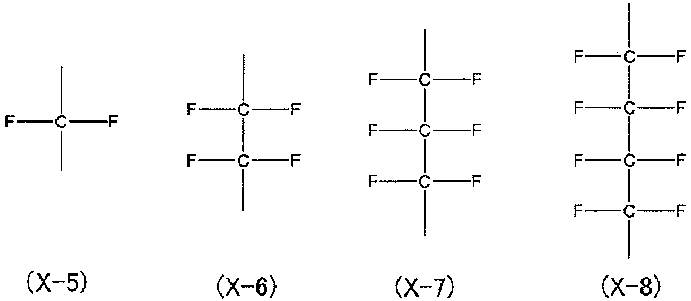

Examples of the repeating unit shown by the general formula (8) include a repeating unit shown by the following general formula (8-1). 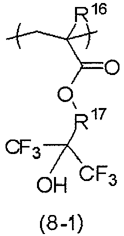 wherein R¹⁶ individually represent a hydrogen atom, an alkyl group having 1 to 4 carbon atoms, a trifluoromethyl group, or a hydroxymethyl group, and R¹⁷ represents a divalent chain-like or cyclic hydrocarbon group.

The description given above in connection with R³² in the general formula (8) may be applied to the divalent chain-like or cyclic hydrocarbon group represented by R¹⁷ in the general formula (8-1).

Examples of a preferable monomer that produces the repeating unit (8-1) shown by the general formula (8-1) include (1,1,1-trifluoro-2-trifluoromethyl-2-hydroxy-3-propyl) (meth)acrylate, (1,1,1-trifluoro-2-trifluoromethyl-2-hydroxy-4-butyl) (meth)acrylate, (1,1,1-trifluoro-2-trifluoromethyl-2-hydroxy-5-pentyl) (meth)acrylate, (1,1,1-trifluoro-2-trifluoromethyl-2-hydroxy-4-pentyl) (meth)acrylate, 2-{[5-(1',1',1'-trifluoro-2'-trifluoromethyl-2'-hydroxy)propyl]bicyclo[2.2.1]heptyl} (meth)acrylate, 4-{[9-(1',1',1'-trifluoro-2'-trifluoromethyl-2'-hydroxy)propyl]tetracyclo[6.2.1.1^{3,6}.0^{2,7}]-dod ecyl} (meth)acrylate, and the like.

Examples of the linear, branched, or cyclic alkyl group having 1 to 12 carbon atoms represented by R¹⁹ in the general formula (9), in which at least one hydrogen atom is substituted with a fluorine atom, include a trifluoromethyl group, a 2,2,2-trifluoroethyl group, a perfluoroethyl group, a perfluoro-n-propyl group, a perfluoro-i-propyl group, a perfluoro-n-butyl group, a perfluoro-i-butyl group, a perfluoro-t-butyl group, a perfluorocyclohexyl group, a2-(1,1,1,3,3,3-hexafluoro)propyl group, a 2,2,3,3,4,4,5,5-octafluoropentyl group, a 2,2,3,3,4,4,5,5-octafluorohexyl group, a perfluorocyclohexylmethyl group, a 2,2,3,3,3-pentafluoropropyl group, a 2,2,3,3,4,4,4-heptafluoropentyl group, a 3,3,4,4,5,5,6,6,7,7,8,8,9,9,10,10,10-heptadecafluorodecyl group, a 5-trifluoromethyl-3,3,4,4,5,6,6,6-octafluorohexyl group, and the like.

Examples of a preferable monomer that produces the repeating unit (9) shown by the general formula (9) include trifluoromethyl (meth)acrylate, 2,2,2-trifluoroethyl (meth)acrylate, perfluoro-ethyl (meth)acrylate, perfluoro-n-propyl (meth)acrylate, perfluoro-i-propyl (meth)acrylate, perfluoro-n-butyl (meth)acrylate, perfluoro-i-butyl (meth)acrylate, perfluoro-t-butyl (meth)acrylate, perfluorocyclohexyl (meth)acrylate, 2-(1,1,1,3,3,3-hexafluoro)propyl (meth)acrylate, 1-(2,2,3,3,4,4,5,5-octafluoro)pentyl (meth)acrylate, 1-(2,2,3,3,4,4,5,5-octafluoro)hexyl (meth)acrylate, perfluorocyclohexylmethyl (meth)acrylate, 1-(2,2,3,3,3-pentafluoro)propyl (meth)acrylate, 1-(2,2,3,3,4,4,4-heptafluoro)penta (meth)acrylate, 1-(3,3,4,4,5,5,6,6,7,7,8,8,9,9,10,10,10-heptadecafluoro)decyl (meth)acrylate, 1-(5-trifluoromethyl-3,3,4,4,5,6,6,6-octafluoro)hexyl (meth)acrylate, and the like.

The fluorine-containing resin (C) may include at least one of the repeating unit (2), the repeating unit (3), the repeating unit (4), and the additional repeating unit mentioned above in connection with the resin (A) as an additional repeating unit in addition to the repeating unit (a2), the repeating unit (8), and the repeating unit (9).

The content of the repeating unit (a2) in the fluorine-containing resin (C) is preferably 95 mol% or less, more preferably 10 to 90 mol%, and still more preferably 10 to 85 mol%, based on the total amount (=100 mol%) of the repeating units included in the fluorine-containing resin (C). If the content of the repeating unit (a2) is less than 10 mol%, sufficient developability may not be obtained. When the content of the repeating unit (a2) is 95 mol% or less, a high receding contact angle can be achieved during liquid immersion lithography, and elution of the acid generator and the like from the resist film can be suppressed.

The content of the repeating units (8) and (9) in the fluorine-containing resin (C) is preferably 5 to 90 mol%, more preferably 10 to 90 mol%, and still more preferably 15 to 90 mol%, based on the total amount (=100 mol%) of the repeating units included in the fluorine-containing resin (C). If the content of the repeating units (8) and (9) is less than 5 mol%, a high receding contact angle may not be achieved during liquid immersion lithography, or elution of the acid generator and the like from the resist film may not be suppressed. If the content of the repeating units (8) and (9) exceeds 90 mol%, sufficient developability may not be obtained.

The content of the additional repeating unit in the fluorine-containing resin (C) is preferably 70 mol% or less, more preferably 65 mol% or less, and still more preferably 60 mol% or less, based on the total amount (=100 mol%) of the repeating units included in the fluorine-containing resin (C). If the content of the additional repeating unit exceeds 70 mol%, a high receding contact angle may not be achieved during liquid immersion lithography, or elution of the acid generator and the like from the resist film may not be suppressed.

The fluorine-containing resin (C) may be produced in the same manner as the resin (A) using monomers that produce the respective repeating units.

The fluorine content in the fluorine-containing resin (C) is 3 atom% or more, preferably 3 to 50 atom%, and more preferably 5 to 30 atom%, based on the total amount (=100 atom%) of atoms included in the fluorine-containing resin (C).

The fluorine content may be determined by ¹³C-NMR.

The polystyrene-reduced weight average molecular weight (Mw) of the fluorine-containing resin (C) determined by gel permeation chromatography (GPC) is not particularly limited, but is preferably 1000 to 100,000, more preferably 1000 to 30,000, and still more preferably 1000 to 20,000. If the Mw of the fluorine-containing resin (C) is less than 1000, the heat resistance of the resulting resist may deteriorate. If the Mw of the fluorine-containing resin (C) exceeds 100,000, the developability of the resulting resist may deteriorate.

The ratio (Mw/Mn) of the Mw to the polystyrene-reduced number average molecular weight (Mn) of the fluorine-containing resin (C) determined by GPC is preferably 1.0 to 5.0, more preferably 1.0 to 3.0, and still more preferably 1.0 to 2.0.

The radiation-sensitive resin composition according to one embodiment of the invention may include only one type of fluorine-containing resin (C), or may include two or more of types of fluorine-containing resin (C).

The content (solid content) of the fluorine-containing resin (C) in the radiation-sensitive resin composition according to one embodiment of the invention is normally 0.1 to 20 parts by mass, preferably 0.1 to 5 parts by mass, and more preferably 0.5 to 3 parts by mass, based on 100 parts by mass of the resin (A). If the content f the fluorine-containing resin (C) is less than 0.1 parts by mass, the fluorine-containing resin (C) may not sufficiently provide the surface of the resist film with water repellency during liquid immersion lithography. As a result, elution of components from the resist film to an immersion liquid may occur, or droplets may remain when implementing liquid immersion lithography by a high-speed scan, so that watermark defects may occur. If the content of the fluorine-containing resin (C) exceeds 20 parts by mass, the resist performance (e.g., LWR, development defect resistance, and pattern collapse resistance) may deteriorate.

### [1-4] Lactone compound (D)

The lactone compound (D) causes the fluorine-containing resin (C) that provides the surface of the resist film with water repellency during liquid immersion lithography to be efficiently segregated on the surface of the resist film. Therefore, the amount of the fluorine-containing resin (C) added to the radiation-sensitive resin composition can be reduced by adding the lactone compound (D) to the radiation-sensitive resin composition. This makes it possible to allow the surface of the resist film to exhibit water repellency without impairing the basic resist performance (e.g., LWR, development defect resistance, and pattern collapse resistance), so that elution of components from the resist film to an immersion liquid can be suppressed, or liquid immersion lithography can be implemented by a high-speed scan without causing droplets to remain (i.e., defects (e.g., watermark defect) that may occur due to liquid immersion lithography can be suppressed).

Specific examples of the lactone compound (D) include γ-butyrolactone, valerolactone, mevalonic lactone, norbornane lactone, and the like.

The radiation-sensitive resin composition according to one embodiment of the invention may include only one type of lactone compound (D), or may include two or more of types of lactone compound (D).

The content of the lactone compound (D) in the radiation-sensitive resin composition according to one embodiment of the invention is 50 to 200 parts by mass, and preferably 50 to 150 parts by mass, based on 100 parts by mass of the resin (A), so that the fluorine-containing resin (C) that is added in a reduced amount can be segregated on the surface of the resist film, so that the surface of the resist film exhibits sufficient water repellency when adding the fluorine-containing resin (C) in a reduced amount. If the content of the lactone compound (D) exceeds 200 parts by mass, the basic performance and the shape of the resulting resist may significantly deteriorate.

### [1-5] Acid diffusion controller (E)

The radiation-sensitive resin composition according to one embodiment of the invention may further include the acid diffusion controller (E) in addition to the resin (A), the acid generator (B), the fluorine-containing resin (C), and the lactone compound (D).

The acid diffusion controller (E) controls a phenomenon in which an acid generated by the acid generator upon exposure is diffused in the resist film, and suppresses undesired chemical reactions in the unexposed area. The acid diffusion controller (E) improves the storage stability of the resulting radiation-sensitive resin composition, improves the resolution of the resulting resist, and suppresses a change in line width of the resist pattern due to a change in post-exposure delay (PED) from exposure to post-exposure bake. This makes it possible to obtain a composition that exhibits excellent process stability.

For example, a compound (acid diffusion controller (e1)) shown by the following general formula (10) may suitably be used as the acid diffusion controller (E). 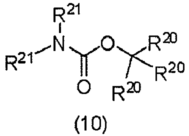 wherein R²⁰ and R²¹ individually represent a hydrogen atom, a substituted or unsubstituted linear, branched, or cyclic alkyl group having 1 to 20 carbon atoms, an aryl group, or an aralkyl group, provided that R²⁰ or R²¹ may bond to each other to form a saturated or unsaturated divalent hydrocarbon group having 4 to 20 carbon atoms, or a derivative thereof, together with the carbon atom bonded thereto.

Examples of the acid diffusion controller (e1) shown by the general formula (10) include N-t-butoxycarbonyl group-containing amino compounds such as N-t-butoxycarbonyl-di-n-octylamine, N-t-butoxycarbonyl-di-n-nonylamine, N-t-butoxycarbonyl-di-n-decylamine, N-t-butoxycarbonyl dicyclohexylamine, N-t-butoxycarbonyl-1-adamantylamine, N-t-butoxycarbonyl-2-adamantylamine, N-t-butoxycarbonyl-N-methyl-1-adamantylamine, (S)-(-)-1-(t-butoxycarbonyl)-2-pyrrolidinemethanol, (R)-(+)-1-(t-butoxycarbonyl)-2-pyrrolidinemethanol, N-t-butoxycarbonyl-4-hydroxypiperidine, N-t-butoxycarbonylpyrrolidine, N-,N'-di-t-butoxycarbonylpiperazine,
N,N-di-t-butoxycarbonyl-1-adamantylamine, N,N-di-t-butoxycarbonyl-N-methyl-1-adamantylamine, N-t-butoxycarbonyl-4,4'-diaminodiphenylmethane, N,N'-di-t-butoxycarbonylhexamethylenediamine, N,N,N',N'-tetra-t-butoxycarbonylhexamethylenediamine, N,N'-di-t-butoxycarbonyl-1,7-diaminoheptane, N,N'-di-t-butoxycarbonyl-1,8-diaminooctane, N,N'-di-t-butoxycarbonyl-1,9-diaminononane, N,N'-di-t-butoxycarbonyl-1,10-diaminodecane, N,N'-di-t-butoxycarbonyl-1,12-diaminododecane, N,N'-di-t-butoxycarbonyl-4,4'-diaminodiphenylmethane, N-t-butoxycarbonylbenzimidazole, N-t-butoxycarbonyl-2-methylbenzimidazole, and N-t-butoxycarbonyl-2-phenylbenzimidazole, and the like.

Further examples of the acid diffusion controller (E) include tertiary amine compounds, quaternary ammonium hydroxide compounds, nitrogen-containing heterocyclic compounds, and the like.

Examples of the tertiary amine compounds include tri(cyclo)alkylamines such as triethylamine, tri-n-propylamine, tri-n-butylamine, tri-n-pentylamine, tri-n-hexylamine, tri-n-heptylamine, tri-n-octylamine, cyclohexyl dimethylamine, dicyclohexyl methylamine, and tricyclohexylamine; aromatic amines such as aniline, N-methylaniline, N,N-dimethylaniline, 2-methylaniline, 3-methylaniline, 4-methylaniline, 4-nitroaniline, 2,6-dimethylaniline, and 2,6-diisopropylaniline; alkanolamines such as triethanolamine and N,N-di(hydroxyethyl)aniline; N,N,N',N'-tetramethylethylenediamine, N,N,N',N'-tetrakis(2-hydroxypropyl)ethylenediamine, 1,3-bis[1-(4-aminophenyl)-1-methylethyl]benzenetetramethylenediamine, bis(2-dimethylaminoethyl) ether, bis(2-diethylaminoethyl) ether, and the like.

Examples of the quaternary ammonium hydroxide compounds include tetra-n-propylammonium hydroxide, tetra-n-butylammonium hydroxide, and the like.

Examples of the nitrogen-containing heterocyclic compounds include pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, and acridine; piperazines such as piperazine, 1-(2-hydroxyethyl)piperazine; pyrazine, pyrazole, pyridazine, quinoxaline, purine, pyrrolidine, piperidine, 3-piperidino-1,2-propanediol, morpholine, 4-methylmorpholine, 1,4-dimethylpiperazine, 1,4-diazabicyclo[2.2.2]octane, imidazole, 4-methylimidazole, 1-benzyl-2-methylimidazole, 4-methyl-2-phenylimidazole, benzimidazole, 2-phenylbenzimidazole, and the like.

A photodegradable base may also be used as the acid diffusion controller (E). The photodegradable base is an onium salt compound that decomposes upon exposure, and loses basicity (i.e., acid diffusion controllability).

Specific examples of the onium salt compound include sulfonium salt compounds shown by the following general formula (11) and iodonium salt compounds shown by the following general formula (12). 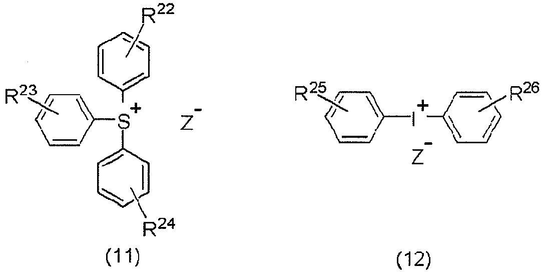 wherein R²² to R²⁶ individually represent a hydrogen atom, an alkyl group, an alkoxyl group, a hydroxyl group, or a halogen atom, and Z⁻ represents OH⁻, R-COO⁻, R-SO₃⁻ (wherein R represents an alkyl group, an aryl group, or an alkaryl group), or an anion shown by the following formula (13).

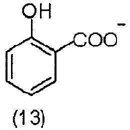

Specific examples of the sulfonium salt compound and the iodonium salt compound include triphenylsulfonium hydroxide, triphenylsulfonium acetate, triphenylsulfonium salicylate, diphenyl-4-hydroxyphenylsulfonium hydroxide, diphenyl-4-hydroxyphenylsulfonium acetate, diphenyl-4-hydroxyphenylsulfonium salicylate, bis(4-t-butylphenyl)iodonium hydroxide, bis(4-t-butylphenyl)iodonium acetate, bis(4-t-butylphenyl)iodonium hydroxide, bis(4-t-butylphenyl)iodonium acetate, bis(4-t-butylphenyl)iodonium salicylate, 4-t-butylphenyl-4-hydroxyphenyliodonium hydroxide, 4-t-butylphenyl-4-hydroxyphenyliodonium acetate, 4-t-butylphenyl-4-hydroxyphenyliodonium salicylate, bis(4-t-butylphenyl)iodonium 10-camphorsulfonate, diphenyliodonium 10-camphorsulfonate, triphenylsulfonium 10-camphorsulfonate, 4-t-butoxyphenyldiphenylsulfonium 10-camphorsulfonate, and the like.

These acid diffusion controller (E) may be used either individually or in combination.

The content of the acid diffusion controller (E) in the radiation-sensitive resin composition according to one embodiment of the invention is preferably less than 10 parts by mass, and more preferably less than 5 parts by mass, based on 100 parts by mass of the resin (A), so that the resulting resist exhibits high sensitivity. If the content of the acid diffusion controller (E) is 10 parts by mass or more, the resulting resist may exhibit significantly low sensitivity. If the content of the acid diffusion controller (E) is less than 0.001 parts by mass, the pattern shape or the dimensional accuracy of the resulting resist may deteriorate depending on the process conditions.

### [1-6] Additive (F)

The radiation-sensitive resin composition according to one embodiment of the invention may optionally include the additive (F) such as an alicyclic skeleton-containing additive (f1), a surfactant (f2), and a sensitizer (f3).

The content of each additive may be appropriately determined depending on the objective.

The alicyclic skeleton-containing additive (f1) improves the dry etching resistance, the pattern shape, adhesion to a substrate, and the like.

Examples of the alicyclic skeleton-containing additive (f1) include adamantane derivatives such as 1-adamantanecarboxylate, 2-adamantanone, t-butyl 1-adamantanecarboxylate, t-butoxycarbonylmethyl 1-adamantanecarboxylate, α-butyrolactone 1-adamantanecarboxylate, di-t-butyl 1,3-adamantanedicarboxylate, t-butyl 1-adamantaneacetate, t-butoxycarbonylmethyl 1-adamantaneacetate, di-t-butyl 1,3-adamantanediacetate, and 2,5-dimethyl 2,5-di(adamantylcarbonyloxy)hexane;
deoxycholates such as t-butyl deoxycholate, t-butoxycarbonylmethyl deoxycholate, 2-ethoxyethyl deoxycholate, 2-cyclohexyloxyethyl deoxycholate, 3-oxocyclohexyl deoxycholate, tetrahydropyranyl deoxycholate, and mevalonolactone deoxycholate; lithocholates such as t-butyl lithocholate, t-butoxycarbonylmethyl lithocholate, 2-ethoxyethyl lithocholate, 2-cyclohexyloxyethyl lithocholate, 3-oxocyclohexyl lithocholate, tetrahydropyranyl lithocholate, and mevalonolactone lithocholate; alkyl carboxylates such as dimethyl adipate, diethyl adipate, dipropyl adipate, di-n-butyl adipate, and di-t-butyl adipate;
3-[2-hydroxy-2,2-bis(trifluoromethyl)ethyl]tetracyclo[4.4.0.1^{2,5}.1^{7,10}]dodecane, 2-hydroxy-9-methoxycarbonyl-5-oxo-4-oxa-tricyclo[4.2.1.0^{3,7}]nonane; and the like.

These alicyclic skeleton-containing additives (f1) may be used either individually or in combination.

The surfactant (f2) improves the applicability, striation, developability, and the like of the radiation-sensitive resin composition.

Examples of the surfactant (f2) include nonionic surfactants such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate, polyethylene glycol distearate, KP341 (manufactured by Shin-Etsu Chemical Co., Ltd.), Polyflow No. 75, Polyflow No. 95 (manufactured by Kyoeisha Chemical Co., Ltd.), EFTOP EF301, EFTOP EF303, EFTOP EF352 (manufactured by JEMCO, Inc.), Megafac F171, Megafac F173 (manufactured by DIC Corporation), Fluorad FC430, Fluorad FC431 (manufactured by Sumitomo 3M Ltd.), Asahi Guard AG710, Surflon S-382, Surflon SC-101, Surflon SC-102, Surflon SC-103, Surflon SC-104, Surflon SC-105, Surflon SC-106 (manufactured by Asahi Glass Co., Ltd.), and the like.

These surfactants (f2) may be used either individually or in combination.

The sensitizer (f3) absorbs the energy of radiation, and transmits the energy to the acid generator (B), so that the amount of acid generated by the acid generator (B) increases. The sensitizer (f3) thus improves the apparent sensitivity of the radiation-sensitive resin composition.

Examples of the sensitizer (f3) include carbazoles, acetophenones, benzophenones, naphthalenes, phenols, biacetyl, eosine, rose bengal, pyrenes, anthracenes, phenothiazines, and the like.

These sensitizers (f3) may be used either individually or in combination.

At least one additive selected from the group consisting of a dye, a pigment, and an adhesion promoter may also be used as the additive (F). For example, the dye or pigment visualizes the latent image in the exposed area, so that the effect of halation during exposure can be reduced. The adhesion promoter improves adhesion to a substrate.

Further examples of the additive (F) include an alkali-soluble resin, a low-molecular-weight alkali solubility controller including an acid-dissociable protecting group, a halation inhibitor, a preservation stabilizer, an antifoaming agent, and the like.

These additives (F) may optionally be used either individually or in combination.

### [1-7] Solvent (G)

An arbitrary solvent that dissolves the resin (A), the photoacid generator (B), the fluorine-containing resin (C), and the lactone compound (D) may be used as the solvent (G). When the radiation-sensitive resin composition includes the acid diffusion controller (E) and the additive (F), it is preferable to use a solvent that also dissolves the acid diffusion controller (E) and the additive (F).

Examples of the solvent (G) include propylene glycol monoalkyl ether acetates such as propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; cyclic ketones such as cyclopentanone, 3-methylcyclopentanone, cyclohexanone, 2-methylcyclohexanone, 2,6-dimethylcyclohexanone, and isophorone;
linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, and 2-octanone; alkyl 2-hydroxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate;
n-propyl alcohol, i-propyl alcohol, n-butyl alcohol, t-butyl alcohol, cyclohexanol, ethylene glycol monomethyl ether, ethylene glycol monoethyl ether, ethylene glycol mono-n-propyl ether, ethylene glycol mono-n-butyl ether, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, ethylene glycol mono-n-propyl ether acetate, propylene glycol monomethyl ether, propylene glycol monoethyl ether, propylene glycol mono-n-propyl ether, toluene, xylene, 2-hydroxy-2-methylethylpropionate,
ethyl ethoxyacetate, ethyl hydroxyacetate, methyl 2-hydroxy-3-methylbutyrate, 3-methoxybutyl acetate, 3-methyl-3-methoxybutyl acetate, 3-methyl-3-methoxybutyl propionate, 3-methyl-3-methoxybutyl butyrate, ethyl acetate, n-propyl acetate, n-butyl acetate, methyl acetoacetate, ethyl acetoacetate, methyl pyruvate, ethyl pyruvate, N-methyl pyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nananol, benzyl alcohol, benzyl acetate, ethyl benzoate, diethyl oxalate, diethyl maleate, ethylene carbonate, propylene carbonate, and the like.

Among these, propylene glycol monoalkyl ether acetates (particularly propylene glycol monomethyl ether acetate) are preferable. Cyclic ketones, linear or branched ketones, alkyl 2-hydroxypropionates, alkyl 3-alkoxypropionate, and the like are also preferable.

These solvents may be used either individually or in combination.

### [3] Photoresist pattern-forming method

The radiation-sensitive resin composition (I) is useful as a radiation-sensitive resin composition for liquid immersion lithography, and particularly useful as a chemically-amplified resist. When using the radiation-sensitive resin composition (I) as a chemically-amplified resist, the acid-dissociable group included in the resin component dissociates due to an acid generated by the acid generator upon exposure so that a carboxyl group is produced. As a result, the solubility of the exposed area of the resist in an alkaline developer increases. Accordingly, the exposed area is dissolved (removed) in an alkaline developer to obtain a positive-tone photoresist pattern.

A photoresist pattern-forming method according to one embodiment of the invention includes (1) forming a photoresist film on a substrate using the above radiation-sensitive resin composition (hereinafter may be referred to as "step (1)"), (2) subjecting the photoresist film to liquid immersion lithography (hereinafter may be referred to as "step (2)"), and (3) developing the photoresist film subjected to liquid immersion lithography to form a resist pattern (hereinafter may be referred to as "step (3)").

In the step (1), a resin composition solution prepared by dissolving the above radiation-sensitive resin composition in a solvent is applied to a substrate (e.g., silicon wafer or silicon dioxide-coated wafer) by an appropriate application method (e.g., rotational coating, cast coating, or roll coating) to form a photoresist film. Specifically, the radiation-sensitive resin composition solution is applied so that the resulting resist film has a given thickness, and prebaked (PB) to volatilize the solvent from the film to obtain a resist film.

The thickness of the resist film is not particularly limited, but is preferably 10 to 5000 nm, and more preferably 10 to 2000 nm.

The prebaking temperature is determined depending on the composition of the radiation-sensitive resin composition, but is preferably about 30 to 200°C, and more preferably 50 to 150°C.

The photoresist pattern-forming method using the radiation-sensitive resin composition according to one embodiment of the invention may optionally include forming a protective film that is insoluble in an immersion liquid on the resist film before the step (2) in order to prevent the immersion liquid from coming in direct contact with the resist film.

Examples of the protective film include a solvent removal-type protective film that is removed using a solvent before the step (3) (see Japanese Patent Application Publication (KOKAI) No. 2006-227632, for example), a developer removal-type protective film that is removed during development in the step (3) (see WO2005-069076 and WO2006-035790, for example), and the like. It is preferable to use the developer removal-type protective film from the viewpoint of throughput and the like.

In the photoresist pattern-forming method using the radiation-sensitive resin composition according to one embodiment of the invention, an organic or inorganic antireflective film may be formed on the substrate (see Japanese Patent Publication (KOKOKU) No. 6-12452 (Japanese Patent Application Publication (KOKAI) No. 59-93448), for example) in order to bring out the potential of the radiation-sensitive resin composition to a maximum extent. A protective film may be formed on the photoresist film (see Japanese Patent Application Publication (KOKAI) No. 5-188598, for example) in order to prevent an adverse effect of basic impurities and the like contained in the environmental atmosphere. The immersion liquid protective film may also be formed on the photoresist film. These methods may be used in combination.

In the step (2), radiation is applied to the photoresist film obtained by the step (1) via an immersion medium (immersion liquid) (e.g., water) (i.e., liquid immersion lithography). In this case, radiation is applied to the photoresist film via a mask having a given pattern.

As radiation used for liquid immersion lithography, visible rays, ultraviolet rays, deep ultraviolet rays, X-rays, electron beams, or the like are appropriately selected depending on the type of acid generator. It is preferable to use ArF excimer laser light (wavelength: 193 nm) or KrF excimer laser light (wavelength: 248 nm). It is particularly preferable use ArF excimer laser light (wavelength: 193 nm).

The exposure conditions (e.g., dose) are appropriately selected depending on the composition of the radiation-sensitive resin composition, the type of additive, and the like. In the photoresist pattern-forming method using the radiation-sensitive resin composition according to one embodiment of the invention, it is preferable to perform post-exposure bake (PEB) after exposure. The acid-dissociable group included in the resin component smoothly dissociates due to PEB.

The PEB temperature is determined depending on the composition of the radiation-sensitive resin composition, but is normally 30 to 200°C, and preferably 50 to 170°C.

In the step (3), the exposed photoresist film is developed to form a given photoresist pattern. It is preferable to use an alkaline aqueous solution prepared by dissolving at least one alkaline compound (e.g., sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide, pyrrole, piperidine, choline, 1,8-diazabicyclo-[5.4.0]-7-undecene, or 1,5-diazabicyclo-[4.3.0]-5-nonene) in water as a developer.

The concentration of the alkaline aqueous solution is preferably 10 mass% or less. If the concentration of the alkaline aqueous solution exceeds 10 mass%, the unexposed area may also be dissolved in the developer.

An organic solvent may be added to the alkaline aqueous solution (developer). Examples of the organic solvent include ketones such as acetone, methyl ethyl ketone, methyl i-butyl ketone, cyclopentanone, cyclohexanone, 3-methylcyclopentanone, and 2,6-dimethylcyclohexanone; alcohols such as methyl alcohol, ethyl alcohol, n-propyl alcohol, i-propyl alcohol, n-butyl alcohol, t-butyl alcohol, cyclopentanol, cyclohexanol, 1,4-hexanediol, and 1,4-hexanedimethylol; ethers such as tetrahydrofuran and dioxane; esters such as ethyl acetate, n-butyl acetate, and i-amyl acetate; aromatic hydrocarbons such as toluene and xylene; phenol, acetonylacetone, dimethylformamide, and the like. These organic solvents may be used either individually or in combination.

The organic solvent is preferably used in an amount of 100 vol% or less based on 100 vol% of the alkaline aqueous solution. If the amount of the organic solvent exceeds 100 vol%, the exposed area may remain undeveloped due to a decrease in developability.

An appropriate amount of a surfactant and the like may also be added to the alkaline aqueous solution (developer).

After development using the alkaline aqueous solution (developer), the resist film is normally washed with water, and dried.

### EXAMPLES

The invention is further described below by way of examples. Note that the invention is not limited to the following examples. In the examples and comparative examples, the unit "parts" refers to "parts by mass", and the unit "%" refers to "mass%" unless otherwise indicated.

### [1] Synthesis of resins (A-1) to (A-5)

Each resin (A) was synthesized as described below. The properties of each resin were measured as follows.

### (1) Mw, Mn, and Mw/Mn

The Mw and the Mn of each resin were measured by gel permeation chromatography (GPC) using GPC columns manufactured by Tosoh Corp. (G2000HXL×2, G3000HXL×1, G4000HXL×1) (flow rate: 1.0 ml/min, eluant: tetrahydrofuran, column temperature: 40°C, standard: monodisperse polystyrene). The dispersity "Mw/Mn" was calculated from the Mw and Mn measurement results.

### (2) ¹³C-NMR analysis

Each resin was subjected to ¹³C-NMR analysis using a system "JNM-EX270" (manufactured by JEOL Ltd.).

### (3) Low-molecular-weight component residual rate

The low-molecular-weight component residual rate was determined by high-performance liquid chromatography (HPLC) using an Intersil ODS-25 µm column (4.6 mm (diameter) × 250 mm) (manufactured by GL Sciences Inc.) (flow rate: 1.0 ml/min, eluant: acrylonitrile/0.1% phosphoric acid aqueous solution). Note that the ratio of components having a polystyrene-reduced weight average molecular weight of 500 or less was calculated as the low-molecular-weight component residual rate.

The structures of monomers (compounds (M-1) to (M-5) and (M-10)) used in each synthesis example are given below.

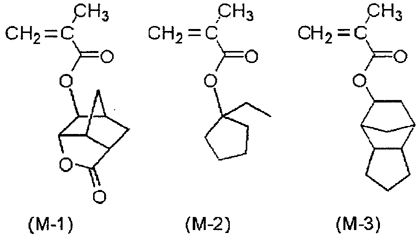

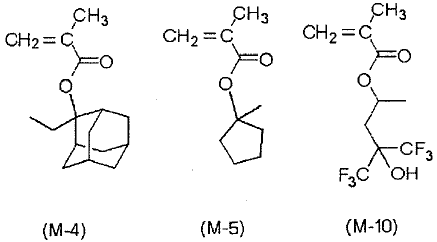

### (Synthesis Example 1)

A monomer solution was prepared by dissolving 53.93 g (50 mol%) of the monomer (M-1), 35.38 g (40 mol%) of the monomer (M-2), and 10.69 g (10 mol%) of the monomer (M-3) in 200 g of 2-butanone, and adding 5.58 g of dimethyl 2,2'-azobis(2-methylpropionate) to the solution. A 500 ml three-necked flask equipped with a thermometer and a dropping funnel was charged with 100 g of 2-butanone, and purged with nitrogen for 30 minutes. The inside of the flask was then heated to 80°C with stirring using a magnetic stirrer. The monomer solution was then added dropwise to the flask using the dropping funnel over 3 hours. The monomers were polymerized for 6 hours from the start of the addition of the monomer solution. After completion of polymerization, the polymer solution was cooled with water to 30°C or less. The polymer solution was then added to 2000 g of methanol, and a precipitated white powder was collected by filtration. The white powder thus collected was washed twice with 400 g of methanol in a slurry state. The product was then collected by filtration, and dried at 50°C for 17 hours to obtain a white powdery copolymer (74 g, yield: 74%).

The copolymer had an Mw of 6900, an Mw/Mn ratio of 1.70, a ratio of repeating units derived from the monomers (M-1), (M-2), and (M-3) determined by ¹³C-NMR analysis of 53.0:37.2:9.8 (mol%), and a content of acid-dissociable group-containing repeating units of 37.2 ml%. The copolymer had a low-molecular-weight component residual rate of 0.13%. This copolymer is referred to as "resin (A-1)" (see the following formula).

The resin (A-1) corresponds to the resin (A) of the radiation-sensitive resin composition (I).

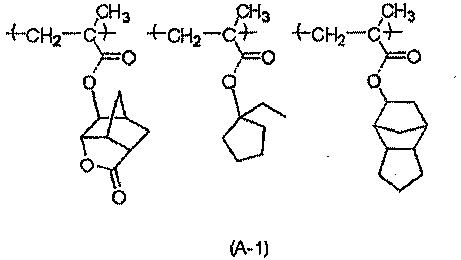

### (Synthesis Example 2)

A monomer solution was prepared by dissolving 47.54 g (46 ml%) of the monomer (M-1), 12.53 g (15 mol%) of the monomer (M-2), and 39.93 g (39 mol%) of the monomer (M-4) in 200 g of 2-butanone, and adding 4.08 g of 2,2'-azobis(isobutylonitrile) to the solution. A 1000 ml three-necked flask equipped with a thermometer and a dropping funnel was charged with 100 g of 2-butanone, and purged with nitrogen for 30 minutes. The inside of the flask was then heated to 80°C with stirring using a magnetic stirrer. The monomer solution was then added dropwise to the flask using the dropping funnel over 3 hours. The monomers were polymerized for 6 hours from the start of the addition of the monomer solution. After completion of polymerization, the polymer solution was cooled with water to 30°C or less. The polymer solution was then added to 2000 g of methanol, and a precipitated white powder was collected by filtration. The white powder thus collected was washed twice with 400 g of methanol in a slurry state. The product was then collected by filtration, and dried at 50°C for 17 hours to obtain a white powdery copolymer (73 g, yield: 73%).

The copolymer had an Mw of 5700, an Mw/Mn ratio of 1.70, a ratio of repeating units derived from the monomers (M-1), (M-2), and (M-4) determined by ¹³C-NMR analysis of 51.4:14.6:34.0 (mol%), and a content of acid-dissociable group-containing repeating units of 48.6 mol%. The copolymer had a low-molecular-weight component residual rate of 0.18%. This copolymer is referred to as "resin (A-2)" (see the following formula).

The resin (A-2) corresponds to the resin (A) of the radiation-sensitive resin composition (I).

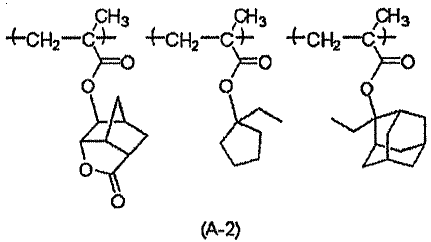

### (Synthesis Example 3)

A monomer solution was prepared by dissolving 42.22 g (40 mol%) of the monomer (M-1), 30.29 g (35 mol%) of the monomer (M-2),15.69 g (15 mol%) of the monomer (M-3), and 11.79 g (10 mol%) of the monomer (M-4) in 200 g of 2-butanone, and adding 6.23 g of dimethyl 2,2'-azobis(2-methylpropionate) to the solution. A 500 ml three-necked flask equipped with a thermometer and a dropping funnel was charged with 100 g of 2-butanane, and purged with nitrogen for 30 minutes. The inside of the flask was then heated to 80°C with stirring using a magnetic stirrer. The monomer solution was then added dropwise to the flask using the dropping funnel over 3 hours. The monomers were polymerized for 6 hours from the start of the addition of the monomer solution. After completion of polymerization, the polymer solution was cooled with water to 30°C or less. The polymer solution was then added to 2000 g of methanol, and a precipitated white powder was collected by filtration. The white powder thus collected was washed twice with 400 g of methanol in a slurry state. The product was then collected by filtration, and dried at 50°C for 17 hours to obtain a white powdery copolymer (79 g, yield: 79%).

The copolymer had an Mw of 5900, an Mw/Mn ratio of 1.69, a ratio of repeating units derived from the monomers (M-1), (M-2), (M-3), and (M-4) determined by ¹³C-NMR analysis of 40.6:35.1:13.9:10.4 (mol%), and a content of acid-dissociable group-containing repeating units of 45.5 mol%. The copolymer had a low-molecular-weight component residual rate of 0.20%. This copolymer is referred to as "resin (A-3)" (see the following formula). The resin (A-3) corresponds to the resin (A) of the radiation-sensitive resin composition (I).

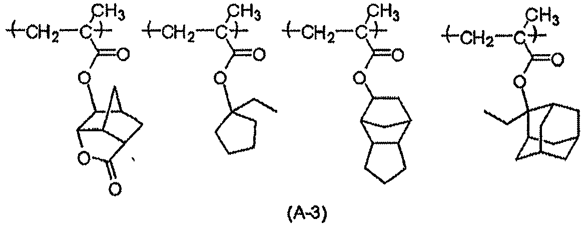

### (Synthesis Example 4)

A monomer solution was prepared by dissolving 56.92 g (50 mol%) of the monomer (M-1) and 43.08 g (50 mol%) of the monomer (M-5) in 200 g of 2-butanone, and adding 6.23 g of dimethyl 2,2'-azobis(2-methylpropionate) to the solution. A 500 ml three-necked flask equipped with a thermometer and a dropping funnel was charged with 100 g of 2-butanone, and purged with nitrogen for 30 minutes. The inside of the flask was then heated to 80°C with stirring using a magnetic stirrer. The monomer solution was then added dropwise to the flask using the dropping funnel over 3 hours. The monomers were polymerized for 6 hours from the start of the addition of the monomer solution. After completion of polymerization, the polymer solution was cooled with water to 30°C or less. The polymer solution was then added to 2000 g of methanol, and a precipitated white powder was collected by filtration. The white powder thus collected was washed twice with 400 g of methanol in a slurry state. The product was then collected by filtration, and dried at 50°C for 17 hours to obtain a white powdery copolymer (80 g, yield: 80%).

The copolymer had an Mw of 8100, an Mw/Mn ratio of 1.45, and a ratio of repeating units derived from the monomers (M-1) and (M-5) determined by ¹³C-NMR analysis of 52.7:47.3 (mol%). The copolymer had a low-molecular-weight component residual rate of 0.10%. This copolymer is referred to as "resin (A-4)" (see the following formula).

The resin (A-4) corresponds to the resin (A) of the radiation-sensitive resin composition (I).

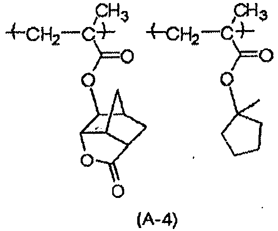

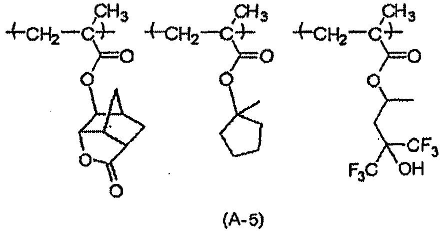

### [2] Synthesis of fluorine-containing polymers (C-1) to (C-3)

### (Synthesis Example 5)

A monomer solution was prepared by dissolving 35.81 g (70 mol%) of a monomer (M-6) shown by the following formula and 14.17 g (30 mol%) of a monomer (M-7) shown by the following formula in 70 g of 2-butanone, and adding 3.23 g of dimethyl 2,2'-azobis(2-methylpropionate) to the solution. A 500 ml three-necked flask was charged with 30 g of 2-butanone, and purged with nitrogen for 30 minutes. The inside of the flask was then heated to 80°C with stirring. The monomer solution was then added dropwise to the flask using a dropping funnel over 3 hours. The monomers were polymerized for 6 hours from the start of the addition of the monomer solution. After completion of polymerization, the polymer solution was cooled with water to 30°C or less, and put in a 21 separating funnel. The polymer solution was diluted with 150 g of n-hexane, and mixed with 600 g of methanol. After the addition of 21 g of distilled water, the mixture was stirred, and allowed to stand for 30 minutes. The lower layer was then collected, and dissolved in propylene glycol monomethyl ether acetate. The solid component (polymer) in the resin solution had the following property values. The yield was 60%.

Specifically, the resulting copolymer had an Mw of 7300, an Mw/Mn ratio of 1.6, a fluorine content of 9.60 atom%, and a ratio of repeating units derived from the monomers (M-6) and (M-7) determined by ¹³C-NMR analysis of 70.5:29.5 (mol%). This copolymer is referred to as "fluorine-containing resin (C-1)".

The fluorine-containing resin (C-1) corresponds to the fluorine-containing resin (C) of the radiation-sensitive resin composition (I),

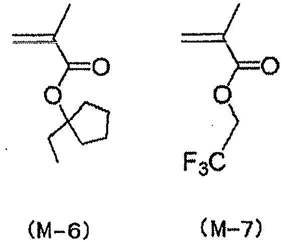

### (Synthesis Example 6)

A monomer solution was prepared by dissolving 54.21 g (60 mol%) of a monomer (M-8) shown by the following formula, 28.02 g (25 mol%) of a monomer (M-9) shown by the following formula, and 17.77 g (15 mol%) of a monomer (M-10) shown by the following formula in 70 g of 2-butanone, and adding 3.23 g of dimethyl 2,2'-azobis(2-methylpropionate) to the solution. A 500 ml three-necked flask was charged with 30 g of 2-butanone, and purged with nitrogen for 30 minutes. The inside of the flask was then heated to 80°C with stirring. The monomer solution was then added dropwise to the flask using a dropping funnel over 3 hours. The monomers were polymerized for 6 hours from the start of the addition of the monomer solution. After completion of polymerization, the polymer solution was cooled with water to 30°C or less, and put in a 21 separating funnel. The polymer solution was diluted with 150 g of n-hexane, and mixed with 600 g of methanol. After the addition of 21 g of distilled water, the mixture was stirred, and allowed to stand for 30 minutes. The lower layer was then collected, and dissolved in propylene glycol monomethyl ether acetate. The solid component (polymer) in the resin solution had the following property values. The yield was 65%.

Specifically, the resulting copolymer had an Mw of 6200, an Mw/Mn ratio of 1.1, a fluorine content of 3.68 atom%, and a ratio of repeating units derived from the monomers (M-8), (M-9), and (M-10) determined by ¹³C-NMR analysis of 60.5:24.0:15.5 (mol%). This copolymer is referred to as "fluorine-containing resin (C-2)".

The fluorine-containing resin (C-2) corresponds to the fluorine-containing resin (C) of the radiation-sensitive resin composition (I).

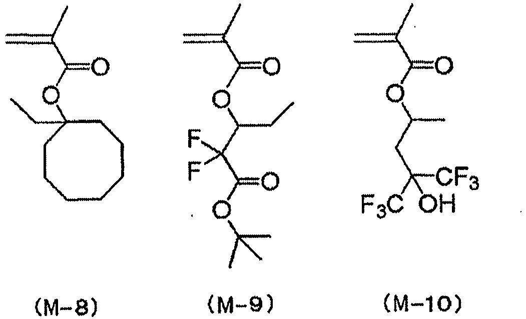

### [3] Preparation of radiation-sensitive resin composition

Radiation-sensitive resin compositions of Examples 1 to 5 and Comparative Examples 1 to 3 were prepared by mixing the resin (A), the acid generator (B), the fluorine-containing resin (C), the lactone compound (D), the acid diffusion controller (E), and the solvent (G) in a ratio shown in Table 1.

**TABLE 1**

| | | (A) | (B) | (C) | (D) | (E) | (G) |
|---|---|---|---|---|---|---|---|
| | | Resin (parts) | Acid generator (parts) | Fluorine-containing resin (parts) | Lactone compound (parts) | Acid diffusion controller (parts) | Solvent (parts) |
| Example | 1 | A-1 (70) | B-1 (4) | C-1 (1.5) | D-1 (100) | E-1 (0.15) | G-1 (875) |
| | | A-2 (30) | B-2 (5) | | | | G-2 (375) |
| | 2 | A-3 (100) | B-1 (4) | C-1 (1.5) | D-1 (100) | E-1 (0.15) | G-1 (875) |
| | | | B-2 (5) | | | | G-2 (375) |
| | 3 | A-4 (100) | B-3 (10.8) | C-2 (2) | D-1 (50) | E-2 (6.4) | G-1 (2700) |
| | | | | | | | G-2 (1150) |
| | 4 | A-4 (100) | B-3 (10.8) | C-2 (2) | D-1 (100) | E-2 (6.4) | G-1 (2700) |
| | | | | | | | G-2 (1150) |
| | 5 | A-4 (100) | B-3 (10.8) | C-2 (2) | D-1 (200) | E-2 (6.4) | G-1 (2700) |
| | | | | | | | G-2 (1150) |
| Comparative Example | 1 | A-1 (70) | B-1 (4) | C-1 (5) | - | E-1 (0.15) | G-1 (875) |
| | | A-2 (30) | B-2 (5) | | | | G-2 (375) |
| | 2 | A-3 (100) | B-1 (4) | C-1 (5) | - | E-1 (0.15) | G-1 (875) |
| | | | B-2 (5) | | | | G-2 (375) |
| | 3 | A-4(100) | B-3 (10.8) | C-2 (2) | - | E-2(6.4) | G-1 (2700) |
| | | | | | | | G-2 (1150) |

The details of the acid generator (B), the lactone compound (D), the acid diffusion controller (E), and the solvent (G) shown in Table 1 are given below. In Table 1, the unit "parts" refers to "parts by mass".

### <Acid generator (B)>

(B-1): triphenylsulfonium nonafluoro-n-butanesulfonate
(B-2): 1-(4-n-butoxynaphthalen-1-yl)tetrahydrothiophenium nonafluoro-n-butanesulfonate
(B-3): compound shown by the following formula

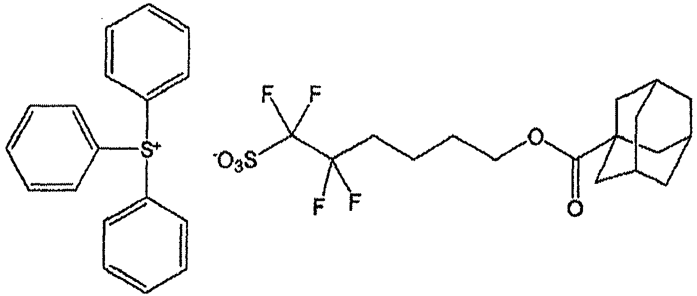

### <Lactone compound (D)>

(D-1): γ-butyrolactone

### <Acid diffusion controller (E)>

(E-1): N-t-butoxycarbonyl-4-hydroxypiperidine
(E-2): triphenylsulfonium salicylate

### <Solvent (G)>

(G-1): propylene glycol monomethyl ether acetate
(G-2): cyclohexanone

### [4] Evaluation

The following properties (1) to (7) of the radiation-sensitive resin compositions of Examples 1 to 5 Comparative Examples 1 to 3 were evaluated. The evaluation results are shown in Table 3.

The properties of the radiation-sensitive resin compositions were evaluated as follows.

### (1) Receding contact angle

The radiation-sensitive resin composition was spin-coated on an 8-inch silicon wafer, and prebaked (PB) on a hot plate at 90°C for 60 seconds to form a film (photoresist film) having a thickness of 120 nm. The receding contact angle was immediately measured by the following method at a temperature of 23°C (room temperature) and a humidity of 45% under atmospheric pressure using a contact angle meter "DSA-10" (manufactured by KRUS).

Specifically, the position of the wafer stage of the contact angle meter was adjusted, and the wafer was placed on the stage. After injecting water into a needle, the position of the needle was finely adjusted to the initial position at which a waterdrop could be formed on the wafer. Water was then discharged from the needle to form a waterdrop (25 µl) on the wafer. After removing the needle, the needle was moved downward to the initial position, and introduced into the waterdrop.
The waterdrop was sucked via the needle for 90 seconds at a rate of 10 µl/min, and the contact angle was measured every second (90 times in total). The average value of twenty contact angle measured values (20 seconds) after the measured value became stable was calculated, and taken as the receding contact angle (°).

### (2) Sensitivity

An organic underlayer film having a thickness of 300 nm was formed on the surface of an 8-inch silicon wafer using a coater/developer ("CLEAN TRACK ACT8" manufactured by Tokyo Electron, Ltd.). An inorganic intermediate film (spin on glass (SOG)) having a thickness of 45 nm was formed on the organic underlayer film to obtain a substrate.

The radiation-sensitive resin composition was spin-coated on the substrate using the coater/developer, and prebaked (PB) under conditions shown in Table 2 to form a resist film having a thickness of 120 nm. The resist film was then exposed via a mask pattern using an ArF excimer laser exposure system ("NSR S306C" manufactured by Nikon Corp., NA 0.78, σ0/σ1=0.93/0.62, Dipole). The resist film was then subjected to PEB under conditions shown in Table 2, developed at 23°C for 30 seconds using a 2.38% tetramethylammonium hydroxide aqueous solution, washed with water, and dried to form a positive-tone resist pattern.

The dose (mJ/cm²) at which a resist pattern having a line width of 75 nm and a line-to-line distance of 75 nm (1:1 line-and-space) was formed was taken as the optimum dose. The optimum dose was evaluated as the sensitivity. The line width and the line-to-line distance were measured using a scanning electron microscope ("S-9380" manufactured by Hitachi High-Technologies Corporation).

### (3) Resolution

The minimum line width (nm) of the line-and-space resist pattern formed when evaluating the sensitivity (1) was evaluated as the resolution ("Resolution (nm)" in Table 3). A small value indicates an excellent resolution.

### (4) LWR

The line width of a 75 nm line-and-space pattern resolved at the optimum dose was observed from above at arbitrary points using the above scanning electron microscope, and a variation 3σ (nm) in line width was evaluated. A small value indicates excellent LWR.

### (5) Pattern collapse resistance

A 75 nm line-and-space pattern resolved at a dose higher than the optimum dose has a line width smaller than that of a 75 nm line-and-space pattern resolved at the optimum dose. In this case, pattern collapse occurs when the line width (dose) has reached a given value. The line width of the pattern when pattern collapse initially occurred was taken as the minimum collapse dimension. The line width (dimension) of the pattern was observed from above using the above scanning electron microscope.

### (6) Pattern shape

The cross-sectional shape of the 75 nm line-and-space pattern of the resist film formed when evaluating the sensitivity was observed using a scanning electron microscope ("S-4800" manufactured by Hitachi High-Technologies Corporation), and the line width Lb in an intermediate area of the resist pattern and the line width La at the top of the resist film were measured. A case where the value "La/Lb" was within the range of "0.9≤La/Lb≤1.1" was evaluated as "Good", and a case where the value "La/Lb" was outside the range of "0.9≤La/Lb≤1.1" was evaluated as "Bad".

### (7) Development defects

An organic underlayer film having a thickness of 300 nm was formed on the surface of an 8-inch silicon wafer using a coater/developer ("CLEAN TRACK ACT8" manufactured by Tokyo Electron, Ltd.). An inorganic intermediate film (spin on glass (SOG)) having a thickness of 45 nm was formed on the organic underlayer film to obtain a substrate.

The radiation-sensitive resin composition was spin-coated on the substrate using the coater/developer, and prebaked (PB) under conditions shown in Table 2 to form a resist film having a thickness of 120 nm. The resist film was then exposed at the optimum dose via frosted glass on which a pattern was not formed. Specifically, the entire wafer was exposed so that exposed areas and unexposed areas were formed in a checkered pattern.

The resist film was then subjected to PEB under conditions shown in Table 2, developed at 23°C for 30 seconds using a 2.38% tetramethylammonium hydroxide aqueous solution, washed with water, and dried to form a development defect evaluation wafer. The number of development defects of the evaluation wafer was measured using a system "KLA2351" (manufactured by KLA-Tencor Corp.). Development defects are normally detected in exposed areas and unexposed areas. Table 3 shows the total number of development defects detected in the exposed areas and the unexposed areas.

**TABLE 2**

| | | PB | | PEB | |
|---|---|---|---|---|---|
| | | Temperature (°C) | Time (sec) | Temperature (°C) | Time (sec) |
| Example | 1 | 125 | 60 | 115 | 60 |
| | 2 | 125 | 60 | 100 | 60 |
| | 3 | 120 | 60 | 105 | 60 |
| | 4 | 120 | 60 | 105 | 60 |
| | 5 | 120 | 60 | 105 | 60 |
| Comparative Example | 1 | 125 | 60 | 115 | 60 |
| | 2 | 125 | 60 | 100 | 60 |
| | 3 | 120 | 60 | 105 | 60 |

**TABLE 3**

| | | Receding contact angle (°) | Sensitivity (mJ/cm²) | Resolution (nm) | LWR (nm) | Pattern collapse (nm) | Pattern shape | Development defects (number) |
|---|---|---|---|---|---|---|---|---|
| Example | 1 | 80 | 34 | 72 | 7.4 | 48 | Good | 217 |
| | 2 | 78 | 34 | 68 | 6.4 | 46 | Good | 324 |
| | 3 | 70 | 40 | 68 | 63 | 45 | Good | 351 |
| | 4 | 76 | 40 | 67 | 6.3 | 46 | Good | 303 |
| | 5 | 78 | 39 | 67 | 6.2 | 46 | Good | 290 |
| Comparative Example | 1 | 80 | 33 | 75 | 7.8 | 51 | Good | 773 |
| | 2 | 78 | 33 | 72 | 6.7 | 48 | Good | 10216 |
| | 3 | 68 | 40 | 70 | 6.5 | 48 | Good | 3542 |

As shown in Table 3, the radiation-sensitive resin compositions including a given amount of the lactone compound (D) produced a resist film having a sufficiently water-repellent surface that suppresses watermark defects and bubble defects during liquid immersion lithography, achieved an excellent pattern shape, and exhibited excellent basic resist performance (e.g., sensitivity, resolution, LWR, development defect resistance, and pattern collapse resistance).

### INDUSTRIAL APPLICABILITY

The radiation-sensitive resin composition according to the invention can advantageously suppress watermark defects and bubble defects that may occur during liquid immersion lithography. The radiation-sensitive resin composition also produces an excellent pattern shape, and exhibits excellent basic resist performance (e.g., sensitivity, resolution, LWR, development defect resistance, and pattern collapse resistance). Therefore, the radiation-sensitive resin composition may suitably be used for lithography that utilizes an ArF excimer laser or the like as a light source, and may particularly suitably be used for liquid immersion lithography.

## Claims

1. A radiation-sensitive resin composition comprising one or more types of a resin (A) that includes a repeating unit that becomes alkali-soluble due to an acid, but does not include a fluorine-containing repeating unit, (B) a photoacid generator, (C) a fluorine-containing resin that includes a repeating unit that becomes alkali-soluble due to an acid, and a fluorine-containing repeating unit, and (D) a lactone compound, the content of the lactone compound (D) in the composition being 50 to 200 parts by mass based on 100 parts by mass of the one or more types of resin (A).

2. A radiation-sensitive resin composition according to claim 1, wherein the content of the lactone compound (D) in the composition is 50 to 150 parts by mass based on 100 parts by mass of the resin (A).

3. The radiation-sensitive resin composition according to claim 1 or claim 2, wherein the content of the fluorine-containing resin (C) is 0.1 to 20 parts by mass based on 100 parts by mass of the resin (A).

4. The radiation-sensitive resin composition according to any one of claims 1 to 3, wherein the fluorine-containing resin (C) includes at least one of a repeating unit shown by the following general formula (8) and a repeating unit shown by the following general formula (9), 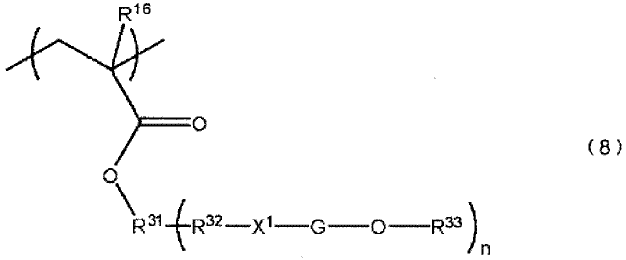 wherein R¹⁶ represents a hydrogen atom, an alkyl group having 1 to 4 carbon atoms, a trifluoromethyl group, or a hydroxymethyl group, R³¹ represents a single bond or an (n+1)-valent chain-like or cyclic hydrocarbon group, R³² individually represents a single bond or a divalent chain-like or cyclic hydrocarbon group, X¹ represents a methylene group substituted with a fluorine atom, or a linear or branched fluoroalkylene group having 2 to 20 carbon atoms, G represents a single bond or -CO-, n is an integer from 1 to 3, and R³³ represents a hydrogen atom or an acid-dissociable group, 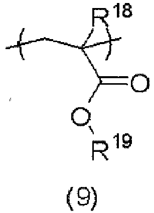 wherein R¹⁸ individually represents a hydrogen atom, an alkyl group having 1 to 4 carbon atoms, a trifluoromethyl group, or a hydroxymethyl group, and R¹⁹ represents a linear, branched, or cyclic alkyl group having 1 to 12 carbon atoms in which at least one hydrogen atom is substituted with a fluorine atom.

5. The radiation-sensitive resin composition according to any one of claims 1 to 4, wherein the fluorine-containing resin (C) includes a repeating unit shown by the following general formula (1c-1), 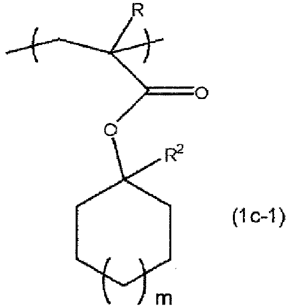 wherein R represents a hydrogen atom, an alkyl group having 1 to 4 carbon atoms, a trifluoromethyl group, or a hydroxymethyl group, R² represents a linear or branched alkyl group having 1 to 4 carbon atoms, and m is an integer from 0 to 4.

6. The radiation-sensitive resin composition according to any one of claims 1 to 5, wherein the resin (A) further includes a repeating unit having a lactone skeleton.

7. A resist pattern-forming method comprising:
(1) forming a photoresist film on a substrate using the radiation-sensitive resin composition according to any one of claims 1 to 6;
(2) subjecting the photoresist film to liquid immersion lithography; and
(3) developing the photoresist film subjected to liquid immersion lithography to form a resist pattern.

## Patentansprüche

1. Strahlungsempfindliche Harzzusammensetzung, die eine oder mehrere Arten eines Harzes (A), das eine Wiederholungseinheit beinhaltet, die aufgrund einer Säure Alkali-löslich wird, aber das keine Fluor-enthaltende Wiederholungseinheit beinhaltet, (B) einen Fotosäuregenerator, (C) ein Fluor-enthaltendes Harz, das eine Wiederholungseinheit, die aufgrund einer Säure Alkali-löslich wird, und eine Fluor-enthaltende Wiederholungseinheit beinhaltet, und (D) eine Lactonverbindung umfasst, wobei der Gehalt der Lactonverbindung (D) in der Zusammensetzung 50 bis 200 Massenteile basierend auf 100 Massenteilen der einen oder mehreren Arten von Harz (A) ist.

2. Strahlungsempfindliche Harzzusammensetzung nach Anspruch 1, wobei der Gehalt der Lactonverbindung (D) in der Zusammensetzung 50 bis 150 Massenteile basierend auf 100 Massenteilen des Harzes (A) ist.

3. Strahlungsempfindliche Harzzusammensetzung nach Anspruch 1 oder Anspruch 2, wobei der Gehalt des Fluor-enthaltenden Harzes (C) 0,1 bis 20 Massenteile basierend auf 100 Massenteilen des Harzes (A) ist.

4. Strahlungsempfindliche Harzzusammensetzung nach einem der Ansprüche 1 bis 3, wobei das Fluor-enthaltende Harz (C) zumindest eine von einer durch die folgende allgemeine Formel (8) gezeigten Wiederholungseinheit und einer durch die folgende allgemeine Formel (9) gezeigten Wiederholungseinheit beinhaltet, 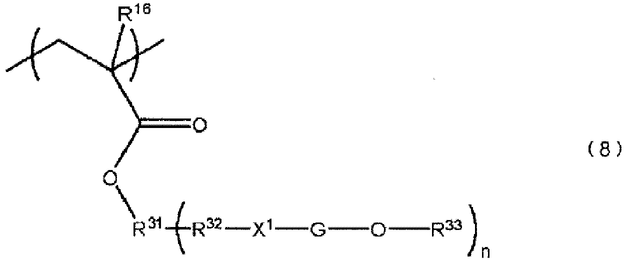 wobei R¹⁶ ein Wasserstoffatom, eine Alkylgruppe mit 1 bis 4 Kohlenstoffatomen, eine Trifluoromethylgruppe oder eine Hydroxymethylgruppe darstellt, R³¹ eine Einfachbindung oder eine (n+1)-valente kettenförmige oder cyclische Kohlenwasserstoffgruppe darstellt, R³² individuell eine Einfachbindung oder eine divalente kettenförmige oder cyclische Kohlenwasserstoffgruppe darstellt, X¹ eine Methylengruppe, die mit einem Fluoratom substituiert ist, oder eine lineare oder verzweigte Fluoroalkylengruppe mit 2 bis 20 Kohlenstoffatomen darstellt, G eine Einfachbindung oder -CO- darstellt, n eine ganze Zahl von 1 bis 3 ist und R³³ ein Wasserstoffatom oder eine Säure-dissoziierbare Gruppe darstellt, 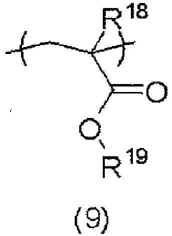 wobei R¹⁸ individuell ein Wasserstoffatom, eine Alkylgruppe mit 1 bis 4 Kohlenstoffatomen, eine Trifluormethylgruppe oder eine Hydroxymethylgruppe darstellt und R¹⁹ eine lineare, verzweigte oder cyclische Alkylgruppe mit 1 bis 12 Kohlenstoffatomen darstellt, in welcher zumindest ein Wasserstoffatom mit einem Fluoratom substituiert ist.

5. Strahlungsempfindliche Harzzusammensetzung nach einem der Ansprüche 1 bis 4, wobei das Fluor-enthaltende Harz (C) eine durch die folgende allgemeine Formel (1c-1) gezeigte Wiederholungseinheit beinhaltet, 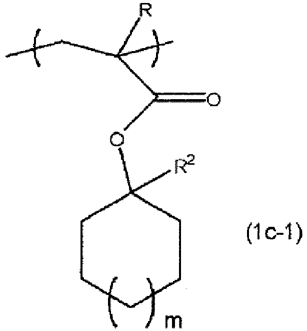 wobei R ein Wasserstoffatom, eine Alkylgruppe mit 1 bis 4 Kohlenstoffatomen, eine Trifluormethylgruppe oder eine Hydroxymethylgruppe darstellt, R² eine lineare oder verzweige Alkylgruppe mit 1 bis 4 Kohlenstoffatomen darstellt und m eine ganze Zahl von 0 bis 4 ist.

6. Strahlungsempfindliche Harzzusammensetzung nach einem der Ansprüche 1 bis 5, wobei das Harz (A) ferner eine Wiederholungseinheit ein mit einem Lactongerüst beinhaltet.

7. Resistmuster-bildendes Verfahren, das umfasst:
(1) Bilden eines Fotoresistfilms auf einem Substrat unter Verwendung der strahlungsempfindlichen Harzzusammensetzung nach einem der Ansprüche 1 bis 6;
(2) Unterwerfen des Fotoresistfilms einer Flüssigeintauchlithographie; und
(3) Entwickeln des Fotoresistfilms, der einer Flüssigeintauchlithographie unterworfen ist, um ein Resistmuster zu bilden.

## Revendications

1. Composition de résine sensible au rayonnement comprenant un ou plusieurs type (s) d'une résine (A) qui inclut une unité répétée qui devient soluble dans les alcalis du fait d'un acide, mais n'inclut pas une unité répétée contenant du fluor, (B) un générateur photoacide, (C) une résine contenant du fluor qui inclut une unité répétée qui devient soluble dans les alcalis du fait d'un acide, et une unité répétée contenant du fluor, et (D) un composé lactone, la teneur du composé lactone (D) dans la composition étant 50 à 200 parties en masse sur la base de 100 parties en masse du ou des type(s) de résine (A).

2. Composition de résine sensible au rayonnement selon la revendication 1, dans laquelle la teneur du composé lactone (D) dans la composition est 50 à 150 parties en masse sur la base de 100 parties en masse de la résine (A).

3. Composition de résine sensible au rayonnement selon la revendication 1 ou la revendication 2, dans laquelle la teneur de la résine contenant du fluor (C) est 0,1 à 20 partie (s) en masse sur la base de 100 parties en masse de la résine (A).

4. Composition de résine sensible au rayonnement selon l'une quelconque des revendications 1 à 3, dans laquelle la résine contenant du fluor (C) inclut au moins une parmi une unité répétée montrée par la formule générale (8) suivante et une unité répétée montrée par la formule générale (9) suivante, 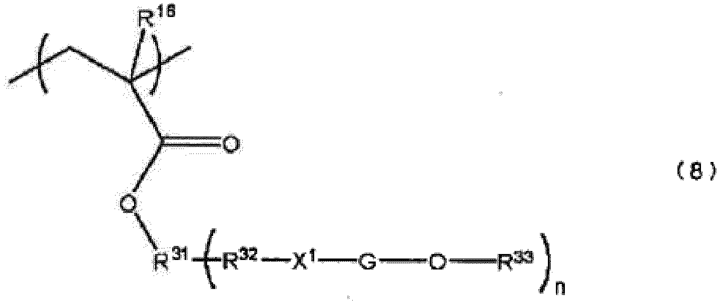 dans laquelle R¹⁶ représente un atome d'hydrogène, un groupe alkyle ayant 1 à 4 atome(s) de carbone, un groupe trifluorométhyle, ou un groupe hydroxyméthyle, R³¹ représente une liaison simple ou un groupe hydrocarboné de type à chaîne ou cyclique (n+1)valent, R³² représente individuellement une liaison simple ou un groupe hydrocarboné de type à chaîne ou cyclique divalent, X¹ représente un groupe méthylène substitué avec un atome de fluor, ou un groupe fluoroalkylène linéaire ou ramifié ayant 2 à 20 atomes de carbone, G représente une liaison simple ou -CO-, n est un entier de 1 à 3, et R³³ représente un atome d'hydrogène ou un groupe dissociable par acide, 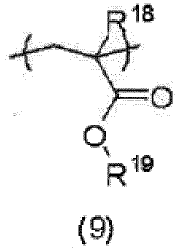 dans laquelle R¹⁸ représente individuellement un atome d'hydrogène, un groupe alkyle ayant 1 à 4 atome(s) de carbone, un groupe trifluorométhyle, ou un groupe hydroxyméthyle, et R¹⁹ représente un groupe alkyle linéaire, ramifié ou cyclique ayant 1 à 12 atome(s) de carbone dans lequel au moins un atome d'hydrogène est substitué avec un atome de fluor.

5. Composition de résine sensible au rayonnement selon l'une quelconque des revendications 1 à 4, dans laquelle la résine contenant du fluor (C) inclut une unité répétée montrée par la formule générale (1c-1) suivante, 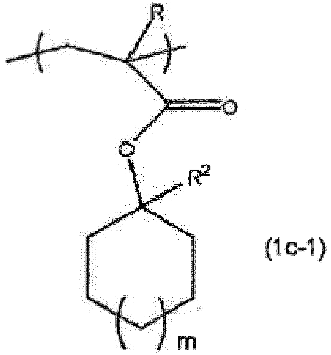 dans laquelle R représente un atome d'hydrogène, un groupe alkyle ayant 1 à 4 atome(s) de carbone, un groupe trifluorométhyle, ou un groupe hydroxyméthyle, R² représente un groupe alkyle linéaire ou ramifié ayant 1 à 4 atome(s) de carbone, et m est un entier de 0 à 4.

6. Composition de résine sensible au rayonnement selon l'une quelconque des revendications 1 à 5, dans laquelle la résine (A) inclut en outre une unité répétée ayant un squelette lactone.

7. Procédé de formation de motif de réserve comprenant :
(1) la formation d'un film de résine photosensible sur un substrat en utilisant la composition de résine sensible au rayonnement selon l'une quelconque des revendications 1 à 6 ;
(2) la soumission du film de résine photosensible à une lithographie à immersion liquide ; et
(3) la révélation du film de résine photosensible soumis à la lithographie à immersion liquide pour former un motif de réserve.
